# EUROPEAN PATENT APPLICATION

(11) **EP 0 867 771 A2**
(43) Date of publication of application: **30.09.1998**
(21) Application number: 98105289.7
(22) Date of filing: 24.03.1998
(51) Int. Cl.: G03F 7/20, G03F 9/00

(54) **Exposure apparatus, exposure method, and circuit making method**

(30) Priority: 24.03.1997 JP 88732/97; 11.04.1997 JP 110379/97; 28.08.1997 JP 247916/97
(71) Applicant: Nikon Corporation, Tokyo 100-8831 (JP)
(72) Inventor: Wakamoto, Shinji, c/o Nikon Corporation, Chiyoda-ku, Tokyo 100-8331 (JP); Imai, Yuji, c/o Nikon Corporation, Chiyoda-ku, Tokyo 100-8331 (JP)
(74) Representative: von Fischern, Bernhard, Dipl.-Ing.

(57) **Abstract**

The present invention relates to an exposure apparatus which eliminates delay in focusing operation and effectively prevents throughput from decreasing, an exposure method utilizing the exposure apparatus, and a circuit making method including the exposure method. In the present invention, in scanning exposure in a shot area positioned near an edge of a photosensitive substrate, the scanning direction of the shot area to be exposed is determined according to the positional relationship between a detection position of a focus detecting system and the photosensitive substrate. Also, in scanning exposure in the shot area positioned near the edge of the photosensitive substrate, the present invention executes focus control and/or leveling control according to the positional relationship between the detection position of the focus detecting system and the photosensitive substrate.

## Description

### BACKGROUND OF THE INVENTION

### Field of the Invention

The present invention relates to a technique related to a scanning type exposure apparatus and the like, and in particular to a scanning type exposure apparatus employed when semiconductor devices, liquid crystal display devices, and the like are made by a lithography process, an exposure method utilizing this apparatus, and a circuit making method including this exposure method.

### Related Background Art

Conventionally used when semiconductor devices, liquid crystal display devices, or the like are made by a lithography process is a projection exposure apparatus which transfers an image of a pattern formed on a mask or reticle (hereinafter referred to as reticle) onto a wafer, glass plate, or the like (hereinafter referred to as wafer) coated with a resist by way of a projection optical system. As such a kind of projection exposure apparatus, a static exposure type stepper, which is a demagnification projection type step-and-repeat exposure apparatus, has been mainly used. On the other hand, recently developed is a step-and-scan scanning type exposure apparatus which successively transfers the image of the reticle pattern to a plurality of shot areas while moving the reticle and wafer relative to the projection optical system. Also in such a scanning type exposure apparatus, as with the stepper, a highly accurate imaging characteristic is necessary for accurately exposing minute circuit patterns, while a high throughput is required since it aims to mass-produce semiconductor devices.

In this kind of scanning exposure apparatus, in order for a shot area on the wafer to coincide with the imaging surface of the projection optical system, the position of a predetermined detection point within the shot area on the wafer to be exposed in the optical axis direction of the projection optical system (position indicating the focus state of the exposure area, hereinafter simply referred to as optical axis direction position) is detected by means of a focus detecting system and, according to thus detected optical axis direction position, the positional adjustment (focus control) of the wafer surface is executed. Also, together with the focus control, adjustment of inclination of the wafer surface (leveling control) is performed.

Meanwhile, in the scanning type exposure apparatus, in the case where scanning exposure is executed for a shot area which is positioned in a peripheral portion of the wafer (near an edge of the wafer) where a part of detection points of the focus detecting system is located outside the wafer at a point of time which is either the point of time when the exposure area is started to be scanned or any point of time from the start to end of scanning (hereinafter referred to as edge shot); when a scanning direction (scan direction) for scanning the exposure area from the outside to inside of the edge is selected, the detection point of the focus point does not exist on the wafer at the point of time where the scanning is started (at scan start), thus making it difficult to capture focus information. In this case, the focus control operation suddenly begins at the position where the detection point enters onto the wafer surface. The periphery of edges of the wafer is a portion where the inclination of the wafer surface or the optical axis direction position tends to greatly fluctuate due to "sagging" of the wafer or resist. Accordingly, in the case where the exposure area is scanned from the outside to inside of the wafer surface (the wafer and reticle are scanned relative to the static projection optical system in practice) in the edge shot as mentioned above, it takes a longer settling time after the start of focus control till the actual focusing, whereby a so-called defocus state is likely to occur due to the delay in focus control.

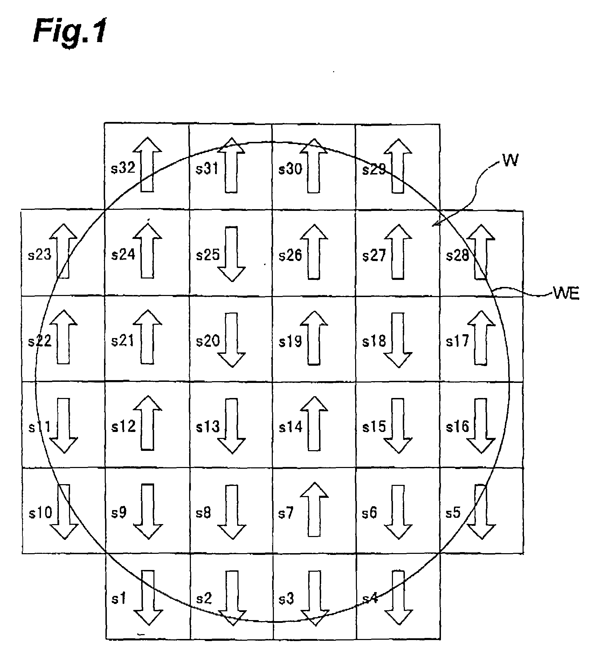

Due to such a reason, as shown in Fig. 1, in the case where edge shots (s1 to s4, s5, s10, s11, s16, s17, s22, s23, and s28 to s32) are employed as exposure areas, the conventional scanning apparatus always selects a direction from the inside to outside of the wafer as the scanning direction for each exposure area, so as to reduce the amount of focus drawing, thereby preventing the defocus state from occurring.

### SUMMARY OF THE INVENTION

As a result of studies concerning the above-mentioned conventional scanning type exposure apparatus, the inventors have found the following problems.

Namely, in the above-mentioned scanning type exposure apparatus, when the scanning direction is always set so as to be directed from the inside to outside of the wafer in the case where edge shots are employed as exposure areas (see shot areas s2 to s6 in Fig. 1, for example), as compared with the case where the scanning direction is reversed after the completion of exposure of one edge shot so as to subject the next shot area (a neighboring shot being usually selected) to exposure, the stepping distance of the wafer becomes longer, and an operation for returning the reticle to the scanning start position, i.e., so-called returning, is necessary. Since such a kind of scanning type exposure apparatus usually employs a demagnification type projection optical system, the moving stroke of the reticle upon scanning exposure becomes a multiple of that of the wafer, thus requiring a large amount of time for the reticle returning operation, whereby throughput may decrease.

Also, in the conventional scanning type exposure apparatus, in the case where the image of the reticle pattern is transferred to a certain shot area on the wafer, immediately before starting exposure, information of the position of the wafer surface in the optical axis direction of the projection optical system at the scanning start position of the exposure area (within the shot area to be subjected to exposure) is measured by a focus sensor, and scanning exposure is executed for each shot area, while a sample table (Z stage), which holds the wafer and is adapted to minutely move in the optical axis direction, is being positioned.

In such a scanning type exposure apparatus, in the shot areas other than the periphery of the wafer, the focus information of the wafer surface immediately before starting exposure can be easily detected, thus yielding no problems. In the case where an edge shot becomes an exposure area, however, in particular when scanning exposure is executed while, within the edge shot, an exposure area conjugate with the illuminated area on the reticle is relatively being scanned from the peripheral portion of the wafer to the inside of the wafer surface (in practice, the wafer is moved while the exposure area is in a static state), if there is a displacement of the wafer surface along the optical axis direction of the projection optical system more than that can be followed by the Z stage, the image of the reticle pattern will be transferred to this shot area in a defocus state.

On the other hand, sometimes employed in order to avoid such a defocus state is a method in which exposure areas in edge shots are always scanned from the inside to outside of the wafer surface. In this method, in order to always relatively scan the reticle and wafer in a constant direction, an operation for returning the reticle stage and wafer stage to a predetermined position is necessary. Accordingly, as compared with the technique in which the image of the reticle pattern is transferred to each shot area while the reticle stage and water stage are operated so as to alternately reverse the scanning direction of the exposure area for each shot area, throughput inevitably decreases.

Also, in the case where the exposure area in the edge shot is always scanned from the outside to inside of the wafer surface, depending on the arrangement of shot areas, the detection point of the focus sensor may be located outside the wafer surface during exposure scanning. In this case, the inclination of the wafer surface cannot be adjusted, whereby the image of the reticle pattern may be transferred to this shot area in a defocus state.

The present invention relates to an exposure apparatus in which, in each of a plurality of shot areas set on a main surface of a photosensitive substrate (including a wafer, glass plate, or the like coated with a photosensitive material such as a resist), a mask and the photosensitive substrate are moved relative to a projection optical system such that an exposure area moves in a predetermined scanning direction, whereby an image of a predetermined pattern provided on the mask is successively transferred to the respective shot areas on the photosensitive substrate (this process being hereinafter referred to as scanning exposure), an exposure method utilizing this exposure apparatus, and a circuit making method including this exposure method; and aims to prevent a defocus state, which may cause color irregularity, and keep the throughput of exposure operation from decreasing.

The exposure apparatus according to the present invention comprises, at least, a mask stage capable of moving while holding the mask so as to change a position of the mask relative to the projection optical system; a substrate stage capable of moving while holding the photosensitive substrate so as to change a position of the photosensitive substrate relative to the projection optical system; a stage control system for controlling movement of the mask stage and movement of the substrate stage; a focus detecting system, installed in a stationary state relative to the projection optical system, for detecting a focus state of the exposure area on the main surface of the photosensitive substrate; a substrate driving system for moving the photosensitive substrate along an optical axis direction of the projection optical system; and a control system for controlling scanning exposure with respect to a shot area selected from a plurality of shot areas.

The focus detecting system detects the focus state of the exposure area according to information obtained from a detection area set on a reference surface including the main surface of the photosensitive substrate, e.g., an area on the photosensitive substrate at least a part of which is set at a position overlapping the exposure area. Upon scanning of the exposure area in each shot area, the mask stage moves while holding the mask so as to change the position of the mask relative to the projection optical system (exposure scanning operation). The substrate stage can perform a stepping operation for moving the photosensitive substrate from the scanning end position of the exposure area in a given shot area to the scanning start position of the exposure area in a shot area which is newly subjected to exposure, and an exposure scanning operation for changing the position of the photosensitive substrate relative to the projection optical system upon scanning of the exposure area in each shot area. The detection area is a concept encompassing a single detection point or detection pattern as well as a plurality of detection points and detection patterns.

In particular, in the first embodiment of the exposure apparatus and exposure method according to the present invention, the control system evaluates a first condition in which the moving distance (stepping distance) of the substrate stage from the scanning end position of the exposure area in a shot area where scanning exposure has been executed prior to a shot area selected from a plurality of shot areas to the scanning start position of the exposure area in the selected shot area is at least a predetermined distance; and a second condition in which, in the scanning exposure in the selected shot area, when an edge of the photosensitive substrate moves relative to the focus detecting system together with movement of the substrate stage, the detection area of the focus detecting system intersects with the edge of the photosensitive substrate from the outside to inside of the main surface of the photosensitive substrate. When both the first and second conditions are satisfied with respect to the selected shot area, the control system can control the stage control system such that the exposure area in the selected shot area is scanned from the inside to outside of the main surface of the photosensitive substrate (first exposure control).

Specifically, in the case where the stepping movement is executed between two shot areas which are separated from each other such that the stepping distance therebetween is at least a predetermined distance (assuming that at least the shot area to become the destination of movement is an edge shot), e.g., one shot area or greater, the detection area of the focus detecting system may be located outside the photosensitive substrate at the point of time when the scanning of the exposure area is started in the shot area at the destination. In this case, both the first and second conditions are satisfied in the shot area to be subjected to exposure. Accordingly, regardless of the scanning direction recorded in shot map data prepared beforehand, the control system moves the photosensitive substrate such that the exposure area is scanned from the inside to outside of the main surface of the photosensitive substrate. Consequently, upon the exposure operation of this shot area, at the point of time when the scanning of the exposure area is started, the detection area of the focus detecting system is positioned on the main surface of the photosensitive substrate, thereby generating no delay in focus control. Thus, the defocus state is prevented from occurring due to the delay in focus control. Though an operation for returning the mask stage is required in the case where the scanning of the exposure area in the prior shot area has been executed from the inside to outside of the main surface of the photosensitive substrate; when the distance corresponding to the time necessary for the stepping movement similar to the time required for the operation for returning the mask stage is set as the predetermined moving distance in the above-mentioned first condition, throughput would hardly decrease substantially.

In the first embodiment of the exposure apparatus and exposure method according to the present invention, when both the first and second conditions are satisfied with respect to the selected shot area, according to a result of detection by the focus detecting system at a detection point set within a local area on the main surface of the photosensitive substrate including the selected shot area, after driving and controlling the substrate control system such that the main surface of the photosensitive substrate coincides with a focal position of the projection optical system, the control system can drive and control the stage control system such that the exposure area in the selected shot area is scanned from the outside to inside of the main surface of the photosensitive substrate (second exposure control).

In particular, this second exposure control is effective, in the case where the stepping movement is executed between two shot areas which are separated from each other such that the stepping distance therebetween is at least a predetermined distance (assuming that at least the shot area to become the destination of movement is an edge shot) , e.g., one shot area or greater, when the scanning direction of the exposure area in the prior shot area is opposite to the scanning direction of the exposure area in the shot area at the destination.

In the second exposure control, in the case where the detection area of the focus detecting system is set at a position where at least a part of the detection area overlaps the exposure area, at the point of time when scanning exposure is started in the shot area at the destination, there is a possibility that the detection area of the focus detecting system maybe located outside the main surface of the photosensitive substrate. Therefore, it is necessary for the control system to move and control the stage control system such that the detection area of the focus detecting system is positioned within the local area on the main surface of the photosensitive substrate. Nevertheless, in the second exposure control, since the operation for returning the mask stage is unnecessary, complete alternate scanning is possible, thus allowing throughput to further improve as compared with the above-mentioned first exposure control.

In order to maintain a desired focus accuracy, it is preferred that the local area on the main surface of the photosensitive substrate where the detection area of the focus detecting system is located be an area defined by a selected shot area and a shot area adjacent to the selected shot area.

In the first embodiment of the exposure apparatus and exposure method according to the present invention, when both the first and second conditions are satisfied with respect to the selected shot area, the control system may selectively execute one of first and second control operations which will be explained in the following (third exposure control). For example, the criterion for selecting the first and second control operations may be based on an operator's setting or may be set according to a relationship between the time for returning the mask and the time for stepping movement of the photosensitive substrate.

Specifically, in the first control operation, the stage control system is driven and controlled such that the exposure area in the selected shot area is scanned from the inside to the outside of the main surface of the photosensitive substrate. On the other hand, in the second control operation, according to a result of detection by the focus detecting system at a detection point set within the local area on the main surface of the photosensitive substrate including the selected shot area, after the substrate control system is driven and controlled such that the main surface of the photosensitive substrate coincides with the focal position of the projection optical system, the stage control system is driven and controlled such that the exposure area in the selected shot area is scanned from the outside to the inside of the main surface of the photosensitive substrate.

The first control operation is a control operation corresponding to the first exposure control, whereas the second control operation is a control operation corresponding to the second exposure control. It is preferred that the local area on the main surface of the photosensitive substrate where the detection area of the focus detecting system is located be an area defined by the selected shot area and a shot area adjacent to the selected shot area. Thus, in the third exposure control, the scanning exposure in each shot area can be performed while the control operation of the stage control system is arbitrarily selected so as to satisfy two demands, i.e, prevention of defocus state and improvement in throughput, to the maximum. In particular, in either control operation, since the focus detection is possible at the point of time when the scanning of the exposure area is started, focus control would not generate a delay which may cause a defocus state. Also, according to circumstances, the third exposure control may arbitrarily select one of the case where the mask stage is preferably returned once, and the case where the substrate stage is preferably returned once in order to execute focus detection.

In the second embodiment of the exposure apparatus and exposure method according to the present invention, the control system can execute leveling control in addition to focus control. Namely, the control system in the second system can detect a positional relationship between a shot area selected from a plurality of shot areas and an edge of the photosensitive substrate and, according to thus detected positional relationship, perform a first adjustment operation (focus control) in which, the substrate driving system is driven and controlled such that the main surface of the photosensitive substrate is moved by a predetermined distance along the optical axis direction of the projection optical system; and/or a second adjustment operation (leveling control) in which the substrate driving system is driven and controlled so as to eliminate an inclination of the main surface of the photosensitive substrate with respect to a plane orthogonal to the optical axis of the projection optical system (fourth exposure control). Instead of the fourth exposure control, the second control system of the second embodiment may execute, upon scanning operation of a shot area selected from the plurality of shot areas, according to at least one of detection information obtained from the focus detecting system and information obtained while a shot area which is subjected to scanning exposure prior to the selected shot area is being subjected to exposure, at least one of a first adjustment operation in which the substrate driving system is driven and controlled such that the main surface of the photosensitive substrate is moved by a predetermined distance along the optical axis direction of the projection optical system; and a second adjustment operation in which the substrate driving system is driven and controlled so as to eliminate the inclination of the main surface of the photosensitive substrate with respect to the plane orthogonal to the optical axis of the projection optical system (fifth exposure control). Here, the substrate driving system comprises a structure which can change the position of the photosensitive substrate so as to move the main surface of the photosensitive substrate along the optical axis direction of the projection optical system, and can change the position of the photosensitive substrate so as to alter the inclination of the main surface of the photosensitive substrate with respect to the plane orthogonal to the optical axis of the projection optical system.

Accordingly, not only in the scanning exposure with respect to the shot areas other than the peripheral portion of the photosensitive substrate, but also in the scanning exposure of the shot areas (edge shots) in the peripheral portion, regardless of the movement of the photosensitive substrate with respect to the projection optical system, as long as the positional relationship between the shot area to be exposed and the edge of the photosensitive substrate is such that the inclination of the photosensitive substrate with respect to the reference surface orthogonal to the optical axis of the projection optical system (i.e., leveling) can also be detected, both the focus control and leveling control of the exposure area on the main surface of the photosensitive substrate are executed. By contrast, when the positional relationship between the shot area and the edge of the photosensitive substrate is such that the leveling control cannot be executed, only the focus control is performed. Namely, the image of the mask pattern is not transferred onto the main surface of the photosensitive substrate in a defocus state, whereby there is no need for taking account of the moving direction of the photosensitive substrate with respect to the projection optical system (scanning direction of the exposure area). Consequently, the most efficient order of exposure can be determined, whereby prevention of the color irregularity caused by the defocus state and improvement in throughput can be attained at the same time.

Whether the control system executs only the focus control or both the focus control and leveling control is judged according to the positional relationship between the shot area to be exposed and the edge of the photosensitive substrate as mentioned above. This positional relationship may include various elements. Hence, more specifically, according to the length of the shortest distance between the scanning start position of the exposure area in the selected shot area and the edge of the photosensitive substrate, the control system may execute the focus control and/or leveling control. Alternatively, according to the length of the shortest distance between the scanning end position of the exposure area in the selected shot area and the edge of the photosensitive substrate, the control system may execute the focus control and/or leveling control.

Preferably, a plurality of detection points in the focus detecting system include elements respectively arranged in one or more rows extending orthogonal to the scanning direction of the exposure area. Ideally, the individual detection points are arranged with a predetermined interval in a grid form on the main surface of the photosensitive substrate.

In the case where a plurality of detection points are thus arranged in a grid form, when satisfied is a first condition in which the distance from the scanning start position of the exposure area in the selected shot area to the edge of the photosensitive substrate along the scanning direction is at least a first value and, of the plurality of detection points of the focus detecting system, at least three points capable of defining the main surface of the photosensitive substrate exist on the main surface of the photosensitive substrate at the point of time when scanning is started, the control system may execute the focus control and leveling control. When satisfied is a second condition in which the distance from the scanning start position of the exposure area in the selected shot area to the edge of the photosensitive substrate along the scanning direction is less than the first value but at least a second value smaller than the first value, and both end detection points in a detection point group arranged in a row orthogonal to the scanning direction and positioned on the main surface of the photosensitive substrate are separated from each other by at least a predetermined distance, the control system may execute the focus control and leveling control. When neither the first condition nor the second condition is satisfied, the control system may execute only the focus control. Also, when satisfied is a third condition in which the distance from the scanning end position of the exposure area in the selected shot area to the edge of the photosensitive substrate along the scanning direction is at least a third value and, of the plurality of detection points of the focus detecting system, at least three points capable of defining the main surface of the photosensitive substrate exist on the main surface of the photosensitive substrate at the point of time when scanning is completed, this control system may execute the focus control and leveling control. When satisfied is a fourth condition in which the distance from the scanning end position of the exposure area in the selected shot area to the edge of the photosensitive substrate along the scanning direction is less than the third value but at least a fourth value smaller than the third value, and both end detection points in a detection point group arranged in a row orthogonal to the scanning direction and positioned on the main surface of the photosensitive substrate are separated from each other by at least a predetermined distance, the control system may execute the focus control and leveling control. When neither the third condition nor the fourth condition is satisfied, the control system may execute only the focus control.

Preferably, in this case, for example, strokes necessary for drawing the substrate driving system for tilting (tilt driving) in the scanning direction and a non-scanning direction are set as the first and third values, strokes necessary for drawing the substrate driving system for tilting (tilt driving) in a non-scanning direction are set as the second and fourth values, and a value based on the resolution of a sensor corresponding to each detection point and the performance of the substrate driving system is set as the distance between the detection points located at the both ends. Here, the control system requires the both end detection points to be separated from each other by at least a predetermined distance since, when their distance is too small, the error included in the detection value in each detection point becomes so influential that correct leveling cannot be executed.

Preferably, the second embodiment further comprises a plurality of sensors prepared so as to respectively correspond to a plurality of detection points of the focus detecting system, and a sensor selecting mechanism for selecting a sensor to be utilized for positional adjustment of the main surface of the photosensitive substrate executed by the control system. In particular, by way of the sensor selecting mechanism, the control system of the second embodiment can additionally select, of a plurality of sensors, a sensor positioned on the main surface of the photosensitive substrate at the point of time when the scanning is started. Also, by way of the sensor selecting mechanism, the control system of the second embodiment can additionally select, of a plurality of sensors, a sensor positioned on the main surface of the photosensitive substrate at the point of time when the scanning is terminated.

In thus configured second embodiment, in the case where each of the second condition and fourth condition in the second embodiment is satisfied, when the number of sensors selected for adjusting the inclination of the main surface of the photosensitive substrate in a non-scanning direction is less with respect to the shot area to be exposed, the number of sensors can be increased so as to adjust the inclination more accurately. This feature is suitable for the case where irregular focus control and leveling control satisfying the second and fourth conditions with respect to so-called chipped shots are excuted.

As explained above, the exposure apparatus according to the second embodiment of the present invention, in any case, can execute focus control including inclination adjustment (leveling control) with a certain degree of accuracy in the scanning direction of the exposure area on the photosensitive substrate and a direction orthogonal thereto. Also, in the exposure method according to the second embodiment of the present invention, since the image of the mask pattern is not transferred onto the main surface of the photosensitive substrate in a defocus state, it becomes unnecessary to take account of the scanning direction of the exposure area in each shot area on the photosensitive substrate. Consequently, the most efficient order of exposure can be determined, whereby prevention of the color irregularity caused by the defocus state and improvement in throughput can be attained at the same time.

The circuit making method according to the present invention includes at least the above-mentioned exposure method and comprises a first step of detecting a positional relation between a shot area selected from a plurality of shot areas and an edge of the photosensitive substrate; a second step of executing, according to thus detected positional relationship, a first adjustment operation (focus control) for moving the main surface of the photosensitive substrate along the optical axis direction of the projection optical system by a predetermined distance and/or a second adjustment operation (leveling control) for adjusting the inclination of the main surface of the photosensitive substrate with respect to a plane orthogonal to the optical axis of the projection optical system; and a third step of transferring the image of the pattern on the mask to a predetermined shot area on the photosensitive substrate after the second step is completed.

In this circuit making method, the image of the mask pattern is not transferred onto the main surface of the photosensitive substrate in a defocus state, thus making it unnecessary to take account of the scanning direction of the exposure area in each shot area on the photosensitive substrate. Also, as a result of this configuration, prevention of the color irregularity caused by the defocus state and improvement in throughput can be attained at the same time.

The present invention will be more fully understood from the detailed description given hereinbelow and the accompanying drawings,which are given by way of illustration only and are not to be considered as limiting the present invention.

Further scope of applicability of the present invention will become apparent from the detailed description given hereinafter. However,it should be understood that the detailed description and specific examples, while indicating preferred embodiments of the invention, are given by way of illustration only, since various changes and modifications within the spirit and scope of the invention will be apparent to those skilled in the art from this detailed description.

### BRIEF DESCRIPTION OF THE DRAWINGS

Fig. 1 is a view showing the order of exposure with respect to a plurality of shot areas on a wafer and the scanning directions of exposure areas in the respective shot areas according to a conventional scanning type exposure apparatus;
Fig. 2 is a view showing a schematic configuration of a scanning type exposure apparatus according to the present invention;
Fig. 3 is a view for explaining the principle of scanning exposure in the scanning type exposure apparatus shown in Fig. 1;
Fig. 4 is a view for explaining an arrangement of slit images, which are respective detection patterns of a multipoint focus detecting system, and their positional relationship to exposure areas in the first embodiment of the present invention;
Fig. 5 is a view showing a schematic configuration of a sensor selecting circuit and a signal processing unit, together with a light-receiving device, in the first embodiment according to the present invention;
Fig. 6 is a flowchart for explaining an operation of a main control system in the first embodiment according to the present invention;
Fig. 7 is a view showing an example of shot map data (including, at least, the order of exposure of individual shot areas and the scanning directions of exposure areas in the respective shot areas) of a plurality of shot areas set on the wafer in the first embodiment according to the present invention;
Fig. 8 is a view showing an example of shot map data in the case where shot areas separated from each other by a predetermined distance on the wafer are respectively exposed in the first embodiment according to the present invention;
Fig. 9 is a view showing a modified example of scanning direction of the exposure area when the first mode is set in the first embodiment according to the present invention;
Fig. 10 is a view showing a modified example of focus detection position and scanning direction of the exposure area when the second mode is set in the first embodiment according to the present invention;
Fig. 11 is a view for explaining an applied example of the scanning type exposure method according to the present invention;
Fig. 12 is a view for explaining an arrangement of slit images, which are respective detection patterns of a multipoint focus detecting system, and their positional relationship to exposure areas in the second embodiment of the present invention;
Fig. 13 is a view showing a schematic configuration of a sensor selecting circuit and a signal processing unit, together with a light-receiving device, in the second embodiment according to the present invention;
Fig. 14 is a flowchart for explaining an operation of a main control system in the second embodiment according to the present invention;
Fig. 15 is a view for explaining a first specific example of focus leveling control according to the flowchart of Fig. 14; and
Fig. 16 is a view for explaining a second specific example of focus leveling control according to the flowchart of Fig. 14.

### DETAILED DESCRIPTION OF THE PREFERRED EMBODIMENTS

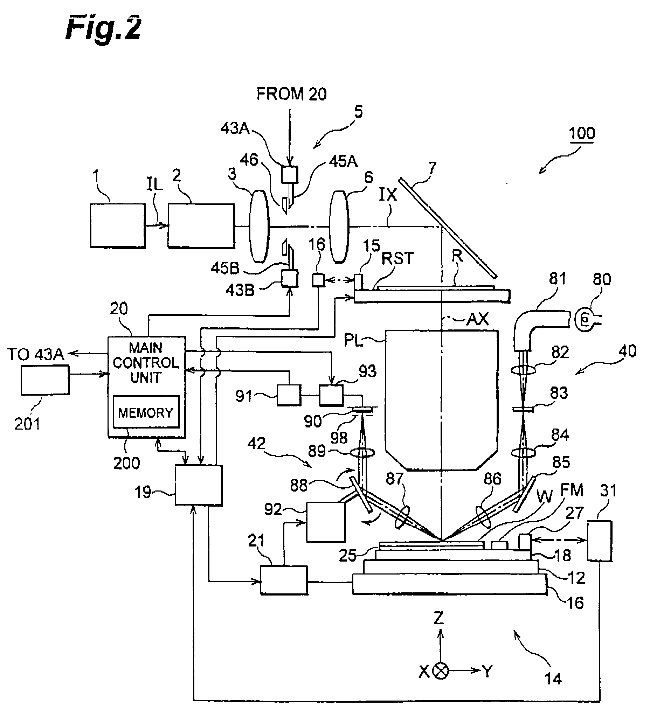

In the following, embodiments of the exposure apparatus and the like according to the present invention will be explained with reference to Figs. 2 to 16.

Fig. 2 is a view showing a schematic configuration of a scanning type exposure apparatus 100 according to the present invention. This scanning type exposure apparatus 100 is a so-called step-and-scan exposure type projection exposure apparatus.

### First Embodiment

The scanning type exposure apparatus 100 according to the first embodiment comprises an illumination system including a light source 1 and an illumination optical system (2, 3, and 5 to 7); a reticle stage RST as a mask stage for holding a reticle R as a mask; a projection optical system PL; an XY stage 14 equipped with a substrate table 18, as a substrate stage, which is capable of moving within XY plane while holding a wafer W as a photosensitive substrate; a stage control system 19 for controlling these stages; and so forth.

The illumination system includes the light source 1; an illuminance homogenizing optical system 2 composed of a collimator lens, a flyeye lens, and the like; a relay lens 3; a reticle blind 5; a relay lens 6; a bending mirror 7; and so forth.

Here, each constituent of the illumination system will be explained together with its operation. After passing through a shutter, illumination light IL as exposure light generated at the light source 1 is converted by the illuminance homogenizing optical system 2 into a luminous flux having substantially a uniform illuminance distribution. As the illumination light IL, for example, excimer laser light such as KrF excimer laser light or ArF excimer laser light, harmonics of copper vapor laser or YAG laser, ultraviolet emission lines (g-line, i-line, etc.) from an extra-high pressure mercury lamp, and the like can be used.

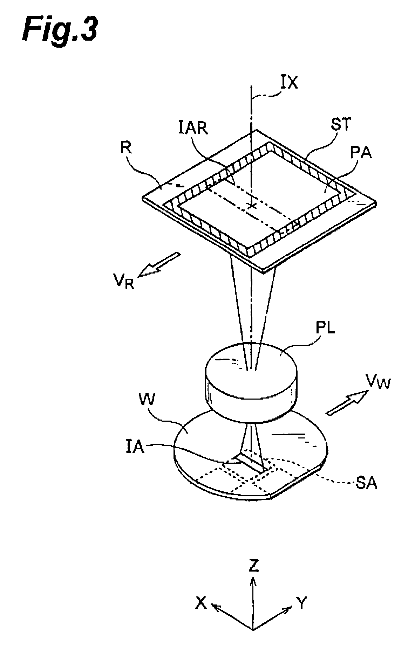

The luminous flux horizontally emitted from the illuminance homogenizing optical system 2 reaches the reticle blind 5 by way of the relay lens 3. The reticle blind 5 is constituted by a movable blind having two sheets of movable blades 45A and 45B (hereinafter the movable blind being also referred to as movable blinds 45A and 45B when appropriate) and a stationary blind 46 with a fixed aperture form disposed near the movable blinds 45A and 45B. The surface where the movable blinds 45A and 45B are disposed is conjugate with the pattern surface of the reticle R. The stationary blind 46 is, for example, a field stop in which a rectangular aperture is surrounded by four pieces of knife edges, whereas the vertical gap of the rectangular aperture is defined by the movable blinds 45A and 45B. Accordingly, the width of a slit-like illumination area IAR (see Fig. 3) illuminating the reticle R can be set to a desired size. The movable blades 45A and 45B are driven by movable blind driving mechanisms 43A and 43B in opening and closing directions. The operations of the movable blind driving mechanisms 43A and 43B are controlled by a main control unit 20 (included in the control system) according to masking information within a file known as a process program stored in a memory 200.

The luminous flux transmitted through the reticle blind 5 passes through the relay lens 6 so as to reach the bending mirror 7, where it is bent vertically downward, thereby illuminating the portion of the reticle R corresponding to the illumination area IAR where a circuit pattern or the like is written.

Onto the reticle stage RST, the reticle R is secured by vacuum suction, for example. In order to position the reticle R, the reticle stage RST is configured so as to be minutely movable within a plane perpendicular to the optical axis IX of the illumination system (coinciding with the optical axis AX of the projection optical system PL explained later) in a two-dimensional fashion (in X-axis direction and Y-axis direction orthogonal thereto, and rotational direction around Z axis orthogonal to both X and Y axes).

Also, the reticle stage RST is movable in a predetermined scanning direction (assumed to be Y-axis direction here) on a reticle base at a designated velocity by a reticle driving section constituted by a linear motor or the like. The reticle stage RST has such a moving stroke that the whole surface of the reticle R can traverse at least the optical axis IX of the illumination optical system.

Secured onto the reticle stage RST is a movable mirror 15 which reflects a laser beam from a reticle laser interferometer (hereinafter referred to as reticle interferometer) 16, whereby the position (displacement) of the reticle stage RST within the stage moving plane is always detected by the reticle interferometer 16, for example, at a resolution of about 0.01 µm. In practice, a movable mirror having a reflecting surface orthogonal to the scanning direction (Y-axis direction) and a movable mirror having a reflecting surface orthogonal to a non-scanning direction (X-axis direction) are disposed on the reticle stage RST, whereas the scanning direction and the non-scanning direction are respectively provided with one axis and two axes of reticle interferometers 16. In Fig. 2, however, they are represented by the movable mirror 15 and reticle interferometer 16.

The positional information of the reticle stage RST from the reticle interferometer 16 is fed to the stage control system 19 and, by way thereof, further to the main control unit 20. In response to an instruction from the main control unit 20, the stage control system 19 drives the reticle stage RST by way of a reticle driving section (not depicted) according to the positional information of the reticle stage RST.

Here, the initial position of the reticle stage RST is determined by a non-depicted reticle alignment system such that the reticle R is accurately positioned at a predetermined reference position. Consequently, by simply measuring the position of the movable mirror 15 by the reticle interferometer 16, it is assured that the position of reticle R has been measured with a sufficiently high accuracy.

The projection optical system PL is placed below the reticle stage RST in Fig. 2. The direction of the optical axis AX of the projection optical system PL (coinciding with the optical axis IX of the illumination optical system) coincides with Z-axis direction. Employed as the projection optical system PL in this embodiment is a refractive optical system comprising a plurality of sheets of lens elements disposed along the direction of the optical axis AX with predetermined intervals so as to yield a both-side telecentric optical arrangement. The projection optical system PL is a demagnification optical system having a predetermined projection magnification, e.g., 1/5 (or 1/4). Consequently, when the illumination area IAR of the reticle R is illuminated with the illumination light IL from the illumination optical system, the illumination light IL transmitted through the reticle R forms, by way of the projection optical system PL, a reduced image of the circuit pattern of the reticle R onto the wafer W (photosensitive substrate) whose surface is coated with a photoresist.

The XY stage 14 has a Y stage 16 adapted to reciprocate on a non-depicted base in Y-axis directions (rightward and leftward in Fig. 2) which are scanning directions; an X stage 12 adapted to reciprocate on the Y stage 16 in X-axis directions (orthogonal to the paper surface in Fig. 2) orthogonal to Y axis; and the substrate table 18 disposed on the X stage 12. Mounted on the substrate table 18 is a wafer holder 25, which holds the wafer W by vacuum suction.

The substrate table 18 is mounted onto the X stage 12 in a state positioned in XY directions while being allowed to move and tilt in the Z-axis direction. The substrate table 18 is supported by non-depicted three shafts respectively at three supporting points different from each other. These three shafts are independently driven by a wafer driving unit 21 in the Z-axis direction, whereby the surface position of the wafer W (its position in the Z-axis direction and inclination with respect to XY plane) held on the substrate table 18 is set to a desired state.

Secured onto the substrate table 18 is a movable mirror 27 which reflects a laser beam from a wafer laser interferometer (hereinafter referred to as wafer interferometer) 31. Accordingly, the position (displacement)of the substrate table 18 within XY plane is always detected by the wafer interferometer 31 disposed outside, for example, at a resolution of about 0.01 µm.

In practice, a movable mirror having a reflecting surface orthogonal to the scanning direction, Y-axis direction, and a movable mirror having a reflecting surface orthogonal to the non-scanning direction, X-axis direction, are disposed on the substrate table 18. On the other hand, the scanning direction and the non-scanning direction are respectively provided with one axis and two axes of wafer interferometers 31. In Fig. 2, however, they are represented by the movable mirror 27 and reticle interferometer 31. The positional information (or velocity information) of the substrate table 18 is fed to the stage control system 19 and, by way thereof, further to the main control unit 20. In response to an instruction from the main control unit 20, the stage control system 19 drives the Y stage 16 and X stage 12 by way of the wafer driving unit 21 (including all the driving systems of the X stage 12, Y stage 16, and substrate table 18) according to the positional information (or velocity information).

Also, secured onto the substrate table 18 is a reference mark plate FM formed with various kinds of reference marks for baseline measurement for measuring the distance from the detection center of an off-axis type alignment detecting system to the optical axis of the projection optical system PL, and the like.

In the scanning type exposure apparatus 100 according to the first embodiment, as shown in Fig. 3, the reticle R is illuminated with the rectangular (slit-like) illumination area IAR whose longitudinal direction is perpendicular to the scanning direction (Y-axis direction) of the reticle R. At the time of exposure, the reticle R is scanned in -Y direction at a velocity V_{R}. An image of the illumination area IAR (whose center substantially coincides with the optical axis AX) is projected onto the wafer W by way of the projection optical system PL, thereby forming a slit-like projection area, i.e., exposure area IA, which is conjugate with the illumination area IAR. Since the wafer W and the reticle R are in an inverted imaging relationship with respect to each other, the wafer W is scanned at a velocity V_{W} in the direction (+Y direction) opposite to the direction of the velocity V_{R} in synchronization with the reticle R. As the exposure area IA and the whole surface of a shot area SA on the wafer W are thus moved relative to each other, the whole surface of the shot area (SA) can be subjected to scanning exposure. The ratio V_{W}/V_{R} of scanning velocities accurately corresponds to the demagnification of the projection optical system PL, whereby the pattern image of a pattern area PA of the reticle R is correctly transferred under demagnification onto the shot area SA on the wafer W. The longitudinal width of the illumination area IAR is set so as to be greater than that of the pattern area PA on the reticle R but smaller than the maximum width of a light-shielding area ST. As the reticle stage RST is scanned, the whole surface of the pattern area PA is illuminated.

In the scanning type exposure apparatus 100, at the time when scanning exposure is executed in each shot area, the main control unit 20 performs positioning (alignment) of the reticle R and wafer W with respect to each other by way of the stage control system 19, wafer driving unit 21, and the like according to a detection signal of a non-depicted alignment detecting system. Also, according to a detection signal of a multipoint focus point detecting system which will be explained later, the main control unit 20 drives and controls the substrate table 18 in the Z-axis direction and the tilted direction by way of the stage control system 19 and the wafer driving unit 21 such that the pattern surface of the reticle R and the wafer W surface become conjugate with each other with respect to the projection optical system PL and such that the imaging surface of the projection optical system PL and the wafer W surface coincide with each other (the wafer surface is within the range of focal depth of the best imaging surface of the projection optical system PL), whereby the surface position is adjusted.

In the scanning type exposure apparatus 100 according to the first embodiment, as the transfer of the reticle pattern to the shot area on the wafer W by scanning exposure such as that mentioned above and the stepping operation to the scanning start position for the next shot area are repeatedly executed, a step-and-scan type exposure operation is performed, whereby the reticle pattern is transferred to all the shot areas on the water W.

The first embodiment further comprises a multipoint focus position detecting system which is one of slanted incident light type focus detecting systems for detecting positions of the portion within the exposure area IA of the wafer W surface and areas in the vicinity thereof in Z direction (direction of the optical axis AX). The multipoint focus position detecting system is constituted by an irradiation optical system 40 comprising an optical fiber bundle 81, a condenser lens 82, a pattern forming plate 83, a lens 84, a mirror 85, and an irradiation objective lens 86; and a light-receiving optical system 42 comprising a condenser objective lens 87, a rotational direction vibrating plate 88, an imaging lens 89, a light-receiving slit 98, and a light-receiving device 90 having a number of photosensors (see Fig. 2).

Here, each constituent of the multipoint focus detecting system (40, 42) will be explained together with its operation. From an illumination light source 80, illumination light with a wavelength to which the photoresist on the wafer W is insensitive, different from the exposure light, is guided to the condenser lens 82 by way of the optical fiber bundle 81. The illumination light emitted from the optical fiber bundle 81 illuminates the pattern forming plate 83 by way of the condenser lens 82.

Formed on the pattern forming plate 83 are 49 pieces of slit-like aperture patterns arranged in a matrix of 7 rows by 7 columns. The illumination light transmitted through each slit-like aperture pattern of the pattern forming plate 83 (image luminous flux of the aperture pattern) is projected onto the exposure surface of the wafer W by way of the lens 84, mirror 85, and irradiation objective lens 86, whereby images of 7 × 7 = 49 slit-like aperture patterns in total on the pattern forming plate 83 are projected and formed onto the exposure surface of the wafer W. In practice, from a direction inclined with respect to the optical axis AX by a predetermined angle α, the image luminous flux of aperture patterns from the irradiation optical system 40 irradiates the wafer W surface (or the surface of the reference mark plate FM) within a plane forming an angle of 45 degrees with respect to each of YZ and XZ planes.

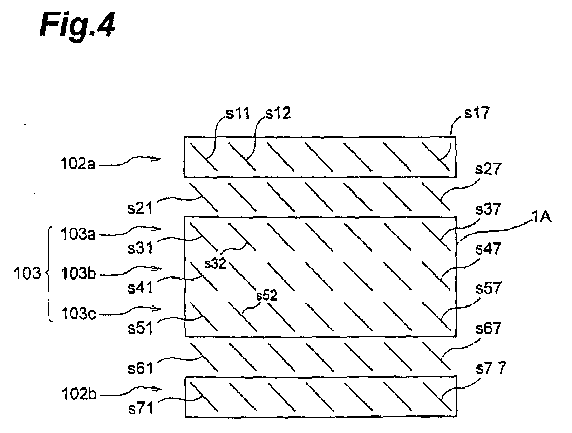

Consequently, as shown in Fig. 4, in the vicinity of the exposure area IA of the wafer W surface, 7 × 7, i.e., 49 images of slit-like aperture patterns (hereinafter referred to as slit images) S₁₁ to S₇₇, in total, arranged in a matrix of 7 rows by 7 columns are formed along X-axis direction and Y-axis direction with substantially the same intervals. A reflected luminous flux of the luminous flux of the slit images S₁₁ to S₇₇ from the wafer W surface advances in a direction inclined with respect to the optical axis AX by a predetermined angle a symmetrically with the image luminous flux from the irradiation optical system 40 and forms images again onto a light-receiving slit plate 98, which is disposed in front of the light-receiving device 90, by way of the condenser objective lens 87, rotational direction vibrating plate 88, and imaging lens 89.

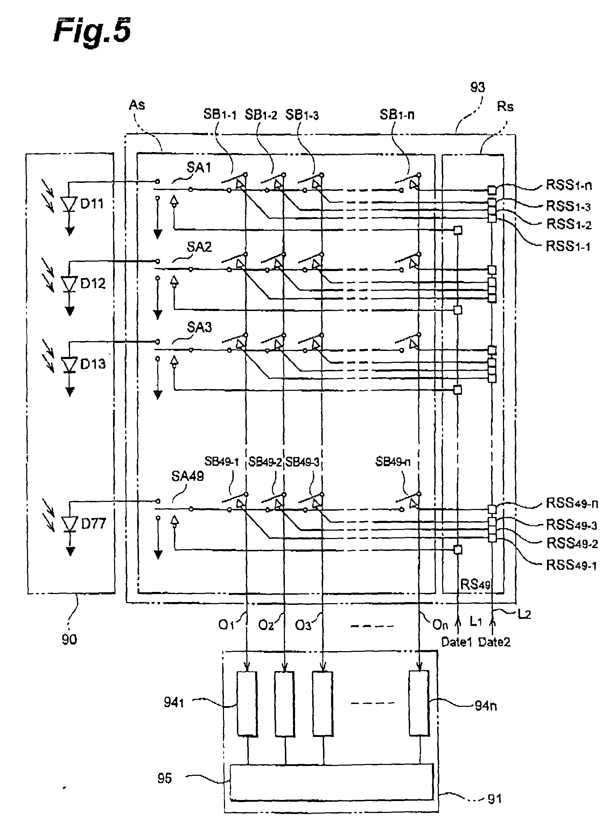

More specifically, on the light-receiving device 90, 49 pieces of photosensors D₁₁ to D₇₇ (see Fig. 5) are arranged in a matrix of 7 rows by 7 columns so as to respectively correspond to the slit images S₁₁ to S₇₇. The light-receiving slit plate 98 disposed at the front surface (lower surface in Fig. 2) of the light-receiving device 90 is formed with slits respectively facing the individual photosensors D, and the slit cages S₁₁ to S₇₇ shown in Fig. 4 respectively re-form images on these slits.

The main control unit 20 accommodates an oscillator (OSC) therein. When a vibrator 92, which is driven by a driving signal from the OSC according to an instruction from the main control unit, applies a predetermined vibration to the rotational direction vibrating plate 88, the position of each of the images re-formed on the light-receiving slit plate 98 vibrates in a predetermined direction (direction orthogonal to the longitudinal direction of each slit of the slit plate 98). Consequently, detection signals of the respective photosensors D₁₁ to D₇₇ are synchronously detected by a signal processing unit 91 according to signals of rotationally vibrating frequencies by way of a sensor selecting circuit 93. Then, a number of focus signals synchronously detected by the signal processing unit 91 are supplied to the main control unit 20. The sensor selecting circuit 93 and signal processing unit 91 will he explained later. Between the imaging lens 89 and the slit plate 98, a plane-parallel for shifting the relative relationship between the slit on the slit plate 98 and the center of vibration of the reflected slit image from the wafer W toward a direction orthogonal to the longitudinal direction of each slit of the slit plate 98 may be disposed.

As can be seen from the foregoing explanation, in the first embodiment, the individual slit images S₁₁ to S₇₇, which are detection points on the wafer W, and the individual photosensors D₁₁ to D₇₇ on the light-receiving device 90 correspond to each other one by one. Accordingly, the information of the position of each slit image on the wafer surface in the Z-axis direction (focus information) can be obtained according to the focus signal, which is an output from each photosensor. Therefore, in the following explanation, the slit images S₁₁ to S₇₇ will be referred to as focus sensors unless it is necessary for them to be specified otherwise in particular.

Of the focus sensors S₁₁ to S₇₇, outputs of the focus sensors S₃₁ to S₃₇ in the third row, focus sensors S₄₁ to s₄₇ in the fourth row, and focus sensors S₅₁ to S₅₇ in the fifth row positioned within the exposure area IA in Fig. 4 are used for follow-up control of the substrate table 18 for setting the surface position within the exposure area IA. Accordingly, these three rows of focus sensors are respectively referred to as follow-up sensors 103a, 103b, and 103c. Also, these three rows of focus sensors are collectively referred to as a follow-up sensor 103.

On the other hand, in the first embodiment, outputs of the first row of focus sensors S₁₁ to S₁₇ and seventh row of focus sensors S₇₁ to S₇₇ are used only for forecasting the next focus state, i.e., whether the wafer W surface changes in +Z or -Z direction, Consequently, these two rows of focus sensors are respectively referred to as pre-reading sensors 102a and 102b. Each of the pre-reading sensors 102a and 102b may be constituted by a plurality of rows of sensors as with the follow-up sensor 103. In this case, leveling control can also be forecasted. For example, outputs of the second row of focus sensors S₂₁ to S₂₇ and sixth row of focus sensors S₆₁ to S₆₇ may also be used as the pre-reading sensors 102a and 102b, respectively.

In the following, configurations of the sensor selecting circuit 93 and signal processing unit 91 will be explained with reference to Fig. 5. This drawing schematically shows the sensor selecting circuit 93 and signal processing unit 91 together with the light-receiving device 90. Among them, the sensor selecting circuit 93 comprises a switch section Aₛ and a register section Rₛ. Disposed within the switch section Aₛ are changeover switches SA₁ to SA₄₉ in each of which one fixed contact is connected to the P side of its corresponding one of the photosensors ( photodiodes herein) D₁₁, D₁₂, ..., and D₇₇ to which a reverse bias voltage is applied; and (49 × n) pieces of make-and-break switches SB₁₋₁, SB₁₋₂, SB₁-₃, ..., and SB₄₉₋ₙ respectively disposed between movable contacts (common contacts) of the changeover switches SA₁ to SA₄₉ and n output lines O₁ to Oₙ. The other fixed contact of each of the changeover switches SA₁ to SA₄₉ is grounded. On the other hand, the N side of each of the photosensors D₁₁ to D₇₇ is connected to a non-depicted power supply circuit. The n output lines O₁ to Oₙ for photoelectrically converted signals are respectively connected to signal processing circuits 94₁ to 94ₙ disposed so as to correspond to these output lines.

As a result of the foregoing configuration, for example, when the changeover switch SA₁ is switched toward the photosensor D₁₁, and the make-and-break switch SB₁₋₁ is turned on, a reverse current (photocurrent, i.e., photoelectrically converted signal) with a strength in proportion to the intensity of light received by the photosensor D₁₁ flows within a closed circuit from the photosensor D₁₁ to the switch SA₁ and the switch SB₁₋₁, successively. This current is detected by the signal processing circuit 94₁ and is converted thereby into a digital signal, which is sent to a signal output circuit 95. On the other hand, for example, when the changeover switch SA₄₉ is switched toward the photosensor D₇₇, and the make-and-break switch SB₄₉₋ₙ is turned on, a reverse current (photocurrent) with a strength in proportion to the intensity of light received by the photosensor D₇₇ flows within a closed circuit from the photosensor D₇₇ to the switch SA₄₉ and the switch SB₄₉₋ₙ,successively. This current is detected by the signal processing circuit 94ₙ and is converted thereby into a digital signal, which is sent to the signal output circuit 95 . Thus, in the first embodiment, when a given combination of changeover switch SA and make-and-break switch SB is turned on, a photocurrent corresponding to the intensity of light received by any photosensor D can be taken out through a desired output line O.

Disposed within the register section Rₛ are 49 pieces of first registers RS₁ to RS₄₉ respectively disposed so as to correspond to the changeover switches SA₁ to SA₄₉; and 49 sets of second registers RSS₁₋₁ to RSS₄₉₋ₙ disposed n by n so as to correspond to the make-and-break switches SB₁₋₁ to SB₄₉₋ₙ The first registers RS₁ to RS₄₉ are commonly connected to a single line L₁, whereas the second registers RSS₁₋₁ to RSS₄₉₋ₙ are commonly connected to a single line L₂. Accordingly, for example, in order for the output of the photosensor D₁₁ to be fed to the output line O₁, Data 1 ("1, 0, 0, ..., 0") and Data 2 ("1, 0, 0, 0, 0, 0, 0, 0, 0, 0, 0, 0, 0, 0, ..., 0, 0, 0, 0, 0, 0, 0") are respectively fed into the lines L₁ and L₂. As a result, while the first register RS₁ and the second register RSS₁₋₁ are set to "1" the other registers become zero. Further, the changeover switch SA₁ is switched toward the photosensor D₁₁, and the make-and-break switch SB₁₋₁ is turned on, whereby the output of the photosensor D₁₁ is fed to the output line O₁. Thus, in the first embodiment, depending on the contents of Data 1 and Data 2 fed into the register RS from the main control unit 20 respectively by way of the lines L₁ and L₂, the output of a desired photosensor D can be fed to a desired output line O, i.e., to the signal processing circuit 94 corresponding thereto. Accordingly, in the case where n = 49, for example, when the individual photosensors D are respectively connected to the signal processing circuits 94₁ to 94ₙ independently of each other, the main control unit 20 can compute the positions of focus sensors, which are individual detection points of the exposure area IA and within detection areas in front thereof and therebehind, in the optical axis direction.

The signal processing unit 91 comprises n pieces of signal processing circuits 94₁ to 94ₙ respectively connected to the output lines O₁ to Oₙ. Each signal processing circuit 94 accommodates therein a synchronous detection circuit (PSD), into which an AC signal having a phase identical to that of the driving signal from the OSC is fed. By using the phase of the AC signal as a reference, each signal processing circuit 94 performs synchronous rectification (synchronous detection) of the signal from its corresponding output line, thereby generating a focus position detection signal (focus signal) FS corresponding to the Z-axis direction position (focus position) of the site of each of the slit images S₁₁ to S₇₇ on the wafer W. Then, the focus signals FS from the signal processing circuits 94₁ to 94ₙ are digitally converted by the signal output circuit 95, so as to be fed to the main control unit 20 as serial data.

Meanwhile, each focus signal FS is a so-called S-curve signal which becomes zero level in the state where the slit center of the light-receiving slit plate 98 coincides with the vibration center of the reflected slit image from the wafer W, a positive level when the wafer W is displaced upward from this state, and a negative level when the wafer W is displaced downward from this state. Accordingly, when no offset is added to each focus signal FS, the height position (optical axis direction position) of the wafer W where each focus signal FS becomes zero level is detected by the main control unit 20 as an in-focus point.

As mentioned above, in the first embodiment, the output of a desired photosensor D can be fed to a desired output line O, i.e., to a signal processing circuit 94 corresponding thereto. For example, in the case where a plurality of photosensors D are set to the same output destination, the signal processing circuit 94 designated (selected) as the output destination synchronously detects the combined signal of photosensor outputs according to the signal of rotational vibration frequency, whereby the digitally converted data of the focus signal corresponding to the combined signal of outputs of the plurality of photosensors are fed to the main control unit 20.

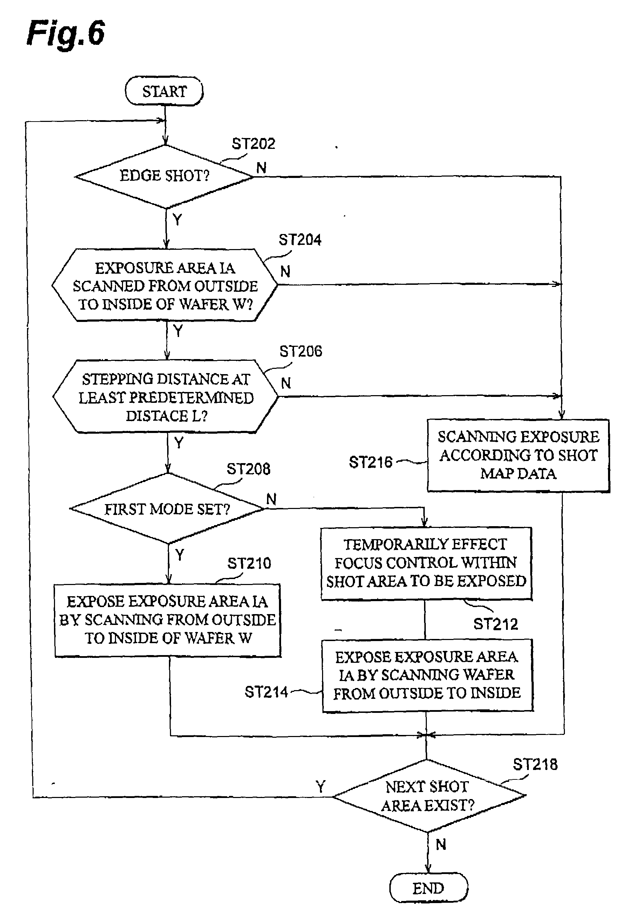

In the following, an exposure sequence in the case where scanning exposure of a reticle pattern is executed on each of a plurality of shot areas on the wafer W in the scanning type exposure apparatus according to the first embodiment configured as mentioned above (see Fig. 2) will be explained with reference to the flowchart of Fig. 6 showing a control operation of the main control unit 20.

As a prerequisite, since the pre-reading sensors 102a and 102b are used only for forecasting the next focus state, it is assumed that the photosensors D₁₁ to D₁₇ corresponding to the respective focus sensors of the pre-reading sensor 102a and the photosensors D₇₁ to D₇₇ corresponding to the respective focus sensors of the pre-reading sensor 102b are respectively connected to the output lines O₁ and Oₙ, each of which is a single output destination, and that the photosensors D₃₁ to D₃₇, D₄₁ to D₄₇, and D₅₁ to D₅₇ corresponding to the respective focus sensors constituting the follow-up sensor 103 are separately connected to output lines O₂ to Oₙ₋₁ (n ≥ 23). Further, since the focus sensors S₂₁ to S₂₇ in the second row and the focus sensors S₆₁ to S₆₇ in the sixth row are not used as can be seen from Fig. 4, their corresponding photosensors D₂₁ to D₂₇ and D₆₁ to D₆₇ are assumed to be connected to no output lines.

Also, it is assumed that, according to a shot arrangement, shot size, exposure order of individual shots, and other necessary data inputted by an operator through a console 201 or the like, shot map data (data defining the exposure order of individual shot areas and scanning directions thereof) have been prepared beforehand and stored in the memory 200 within the main control unit 20.

Further, in the following explanation, "edge shot" refers to a shot area which is a shot area in the peripheral portion of the wafer W, where one of the follow-up sensors 103 is placed outside the effective area of the wafer W at a given point of time during a period extending from the start to end of relative scanning of the reticle R and wafer W for exposure. The peripheral portion of the wafer W is usually tapered so as to form a pattern inhibition zone which is unsuitable for exposure. The outer edge of the pattern inhibition zone is referred to as wafer edge WE, whereas its inside is referred to as effective area or main surface of the water W.

The control algorithm of Fig. 6 is assumed to start at the point of time when the replacement of wafer and the reticle alignment are completed.

First, in order to subject, of a plurality of shot areas set on the main surface of the wafer W, a given shot area to scanning exposure, it is judged whether the shot area to be exposed is an edge shot or not (step ST202). The judgment at the step ST202 is executed according to the shot map data (data indicating the shot area arrangement, exposure order, scanning direction, scanning start position, scanning end position, and the like before a plurality of shot areas within the wafer W are successively subjected to exposure processing) prepared beforehand and stored in the memory 200. If the judgment at this step ST202 is negative, then the scanning exposure of the shot is execut according to the shot map data within the memory 200 (step S216). In this case, the shot area is the one positioned within the wafer W, whereby focus detection is possible at the point of time when the scanning of the exposure area IA is started. Accordingly, before the scanning is started, focus control and leveling control are once performed in a static state. Thereafter, the above-mentioned scanning exposure is executed.

If the judgment at the step ST202 is positive, then it is judged whether the scanning direction of the exposure area IA in the shot area to be exposed is from the outside to inside of the edge WE of the wafer W or not (step ST204). Here, the scanning direction from the outside to inside of the edge WE of the wafer W refers to the case where, assuming the wafer W to be stationary, the exposure area IA is scanned on the stationary water W from the outside to inside of the edge WE (the case where the wafer W is scanned relative to the stationary exposure area IA in practice). The case opposite thereto is referred to as the scanning direction from the inside to outside of the edge WE of the water W. The judgment at this step ST204 is also executed according to the shot map data recorded within the memory 200. If the judgment at the step ST204 is negative, then the scanning exposure according to the shot map data recorded in the memory 200 is executed (step ST216) as mentioned above Also in this case, before the scanning is started, focus control and leveling control are once performed in a static state. Thereafter, the above-mentioned scanning exposure is executed.

If the judgment at the step ST204 is positive, then it is judged whether the stepping distance from the exposure end position of the shot area (previous shot) that has been subjected to scanning exposure immediately prior thereto to the scanning start position for the scanning exposure of the shot area to be exposed is at least a predetermined distance L or not (step ST206). Here, "predetermined distance L" refers to a predetermined distance defining a range in which, in the state where focus control of the shot is started while the focus value (focus information from the photosensor D) at the point of time when completing the focus control of the previous shot is held, the focus value differs from the actual focus detection value (optical axis direction position of the wafer W) so much that, when the above-mentioned technique holding the optical axis direction position of the wafer in the previous shot is used for executing focus control, an impermissible defocus state occurs due to delay in focus control. For example, it is a stepping distance to a shot area separated from the previous shot area by an area corresponding to one shot area in a direction orthogonal to the scanning direction. If the judgment at the step ST206 is negative, then the scanning exposure is executed with respect to the shot area according to the shot map area recorded in the memory 200. Since the shot area to be exposed in this case is an edge shot, which is a shot area where the scanning direction of the exposure area IA is set so as to be directed from the outside to inside of the wafer W while adjoining the previous shot, focus control is executed by using the technique holding the optical axis direction position of the wafer in the previous shot. This holding technique is a technique in which the optical axis direction position of the wafer surface W detected during the scanning exposure in the previous shot is held beforehand and, upon focus detection of the next shot area, focus control for the shot area is executed from thus held optical axis direction position.

If the judgment at the step ST206 is positive, then whether a first mode is set by the operator or not is judged according to information stored at a predetermined area of the memory 200 (step ST208). Here, if the operator has set the first mode beforehand through the console 201 or the like, then the judgment at the step ST208 is made positive. Accordingly, the scanning direction of the exposure area IA is changed so as to be directed from the inside to outside of the wafer W, and the scanning exposure of the shot area is executed (step S210). In this case, after an operation for returning the reticle R is executed together with the stepping to the scanning start position of the next shot on the wafer W, focus control is performed while the wafer W is in a static state, and then the scanning exposure is executed.

If the operator has set a second mode beforehand through the console 201 or the like, then the judgment is negative at the step ST208. In this case, first, in the state where the wafer table 18 is moved so as to place the follow-up sensor 103 within the shot area while the substrate stage 18 is made static, an operation for focus control and leveling control (or focus control in the state where a part of sensors of the follow-up sensor is positioned within the shot area while the wafer W is made static) is executed (step ST212). Subsequently, in the state where the wafer table 18 is returned to the scanning start position, the scanning exposure is executed in conformity to the shot map data (step ST214).

After the scanning exposure of the shot area is executed in any of the above-mentioned steps ST210, ST214, and ST216, it is judged at step ST218 whether there is the next shot area (shot area to be exposed next) or not. If there is the next shot area, the process returns to the step ST202 so as to repeat the foregoing processing and judgment operations. After the scanning exposure of all the shot areas on the wafer W is completed, the judgment at the step ST218 is made positive, whereby a series of control algorithms is completed.

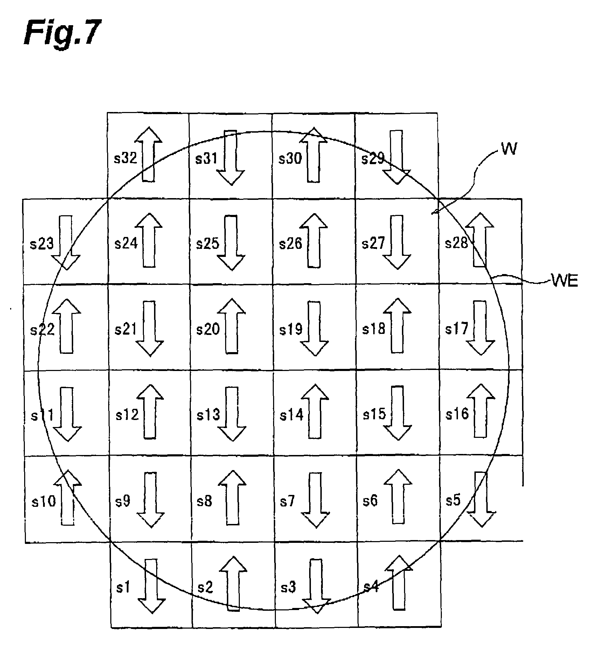

In the following, an example of exposure sequence in conformity to the flowchart explained in the foregoing will be explained with reference to Figs. 7 to 11.

Fig. 7 shows an example of shot map data concerning a plurality of shot areas set within the effective area of the wafer W. In the shot map data shown in Fig. 7, scanning directions (whitened arrows in the drawing) are determined such that, when the shot area arrangement and exposure order (s1 to s32) with respect to the wafer W are determined, complete alternate scanning in which the scanning directions of the wafer W and reticle R are alternately switched according to this order is achieved. In the case where a shot map data such as that shown in Fig. 7 is made, one of judgments at steps ST202, ST204, and ST206 in Fig. 6 is made negative in all the shot areas, whereby scanning exposure is executed according to the shot map data in all the shot areas (see step ST216 in Fig. 6). Also, when complete alternate scanning such as that shown in Fig. 7 is employed, the operation for returning the reticle R is unnecessary, whereby throughput can be maximized.

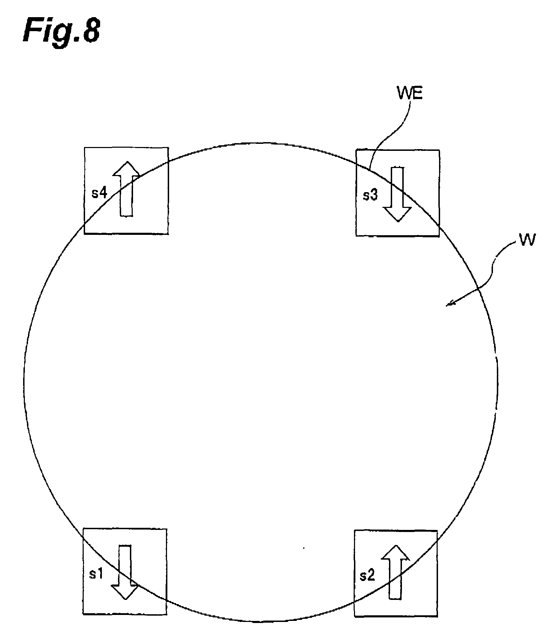

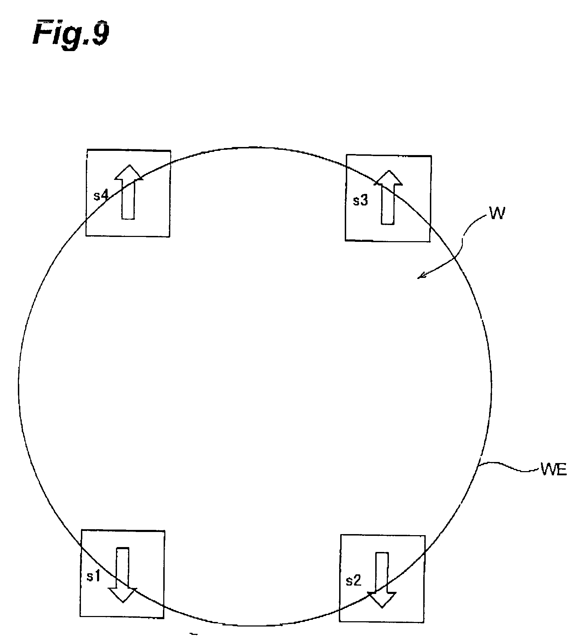

On the other hand, for example, when a shot map data such as that shown in Fig. 8 has been prepared beforehand, then, prior to scanning exposure of the shot area s2, the processing and judgment operations are performed in the order of the above-mentioned steps ST202, ST204, ST206, and ST208. In this case, if the operator has set the first mode beforehand, then the judgment at the step ST208 is made positive, whereby the scanning exposure at step ST210 is executed. As a result, the actual scanning direction of the exposure area IA in the shot area s2 is changed as shown in Fig. 9. Similarly, in this case, with respect to the shot area s3, according to the flow in the order of the above-mentioned steps ST202, ST204, ST206, ST208, and ST210, the scanning direction of the exposure area IA is made opposite to that determined by the shot map (see Fig. 8). In this case, since the scanning direction is directed from the inside to outside of the wafer W, no delay in focus control would occur in the scanning exposure of the shot areas s2 and s3, there by achieving favorable scanning exposure without a defocus state. In the case of Fig. 9, an operation for returning the reticle R is necessary during the period of time between the end of scanning exposure in the shot area s1 and the start of scanning exposure in the shot area s2. Since the stepping distance of the wafer W from the position where the scanning exposure is completed in the shot area s1 and the position where the scanning exposure is started in the shot area s2 is large, however, throughput hardly decreases when, by way of the stage control system 19, the main control unit 20 executes the operation for returning the reticle R in parallel with the stepping of the wafer W, In the case of Fig. 9, though the operation for returning the reticle R is also necessary during the period of time between the end of scanning exposure in the shot area s3 and the start of scanning exposure in the shot area s4, throughput hardly decreases because of a similar reason.

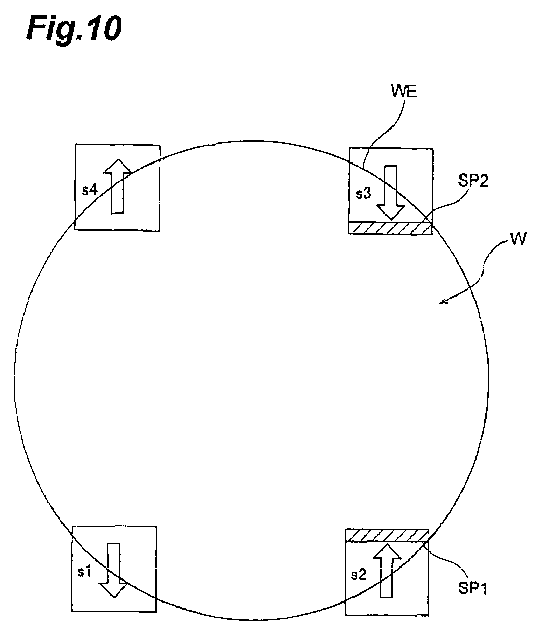

In the case where a shot map data such as that shown in Fig. 8 has been made beforehand, if the operator has set the second mode beforehand, then, prior to the scanning exposure in the shot area s2, the processing and judgment operations are executed in the order of the above-mentioned steps ST202, ST204, ST206, ST208, ST212, and ST214. Subsequently, as shown in Fig. 10, the wafer W is temporarily moved such that the follow-up sensor 103 is positioned within the shot area s2 (e.g., sample position SP1 in Fig. 10) and then, in a static state, focus control and leveling control are executed (or focus control is executed while the wafer W is in a static state with a part of sensors of the follow-up sensor 103 positioned within the shot area). Thereafter, the wafer W is returned to the scanning start position, and the scanning exposure according to the shot map data is executed. In this case, since the focus control and leveling control in the shot area are executed while the wafer W is in a static state, the delay in focus control upon actual scanning exposure would hardly become problematic. As a result, favorable scanning exposure is performed in each shot area without a defocus state. Though it requires some time for the focus control and leveling control in this case, throughput hardly decreases since the operation for returning the reticle is unnecessary

Also, in this case, for the shot area s3, as with the shot area s2, as shown in Fig. 10, the wafer W is temporarily moved such that the follow-up sensor 103 is positioned within the shot area s3 (e.g., sample position SP2 in Fig. 10) and then, in a static state, focus control and leveling control are executed (or focus control is executed while the wafer W is in a static state with a part of sensors of the follow-up sensor 103 positioned within the shot area). Thereafter, the wafer W is returned to the scanning start position, and the scanning exposure according to the shot map data is executed. Also in this case, throughput hardly decreases, whereby favorable scanning exposure is performed in each shot area without a defocus state.

As explained in the foregoing, in the first embodiment, in the case of scanning exposure of an edge shot in which the stepping distance from the previous shot area to this shot area is at least a predetermined value L, and the scanning direction of the exposure area IA in this shot area is directed from the outside to inside of the wafer W, it is possible to set, according to the operator's presetting, the first mode in which the scanning direction is changed such that the exposure area IA is scanned from the outside to inside of the wafer W; and the second mode in which detection is executed by the multipoint focus position detecting system (40, 42) at a position within the shot area on the wafer W, the focus control and leveling control are executed according to the result of detection, and then, with the wafer W returned to the scanning start position, the exposure area IA is scanned from the inside to outside of the wafer W without changing the scanning direction. In the case where the first mode is set, focus information can be captured at the point of time when the scanning is started, whereby there is no possibility of delay occurring in focus control. As a result, favorable scanning exposure is executed in all the shot areas without generating a defocus state. In this case, though an operation for returning the reticle R is necessary during the period of time after the completion of scanning exposure in the previous shot area till the start of scanning exposure in the shot area, throughput hardly decreases, since the stepping distance is long and the operation for returning the reticle R is performed in parallel with the stepping movement. In the case where the second mode is set, the actual scanning exposure is started after the focus control and levelinq control are executed once on the wafer W. As a result, there is substantially no possibility of delay occurring in focus control, whereby favorable scanning exposure without a defocus state is possible in all the shot areas. In this case, though it takes some time to perform the focus control and leveling control once on the wafer W, throughput hardly decreases since the operation for returning the reticle R is unnecessary.

Though the case where the first mode and second mode are set according the operator's presetting is explained in the first embodiment, the above-mentioned step ST210 and steps ST212 and ST214 may be selected automatically. For example, assuming that the stepping distance requiring the same period of time as the operation for returning the reticle R is L2, a control algorithm may be configured such that a judgment step for judging whether the stepping distance is less than L2 (thus at least L but smaller than L2) or not is executed instead of the above-mentioned step ST208, and the processing operations of steps ST212 and ST210 are respectively executed when the judgment is positive and negative. In this case, the focus control and leveling control similar to those of the second mode are performed when the period of time necessary for stepping movement is shorter than that required for the returning operation of the reticle R, whereas the focus control and leveling control similar to those of the first mode are performed when the period of time necessary for stepping movement is the same as or longer than that required for the returning operation of the reticle R. As a result, throughput is prevented from decreasing as much as possible, whereby favorable exposure can be executed without generating a defocus state.

Though the first embodiment relates to the cases where, immediately before starting the scanning exposure of each shot area on the wafer W, it is decided that the scanning direction is changed according to the control algorithm of Fig. 6 or pre-focusing is executed, the present invention should not be restricted thereto. For example, long before starting the exposure, i.e., at the point of time when the exposure processing program is made, a shot map data prepared beforehand in response to the operator's instruction may be modified according to an algorithm similar to the control algorithm of Fig. 6. Thus modified shot map data may be stored in the memory 200, so that the scanning exposure, focus control, and/or leveling control can be executed simply according to the modified shot map data when the actual scanning exposure in each shot is performed. Effects equivalent to those of the first embodiment can be obtained in this case as well.

Though the first embodiment relates to the case using a multipoint focus position detecting system as a focus detecting system for detecting the focus state of the exposure area IA on the wafer W surface or of the area in the vicinity thereof, the present invention should not be restricted thereto. For example, in place of the multipoint focus position detecting system, a focal position detecting system involving only one detection point within the exposure area may be used. Also, in this case, a leveling detecting system may be provided separately.

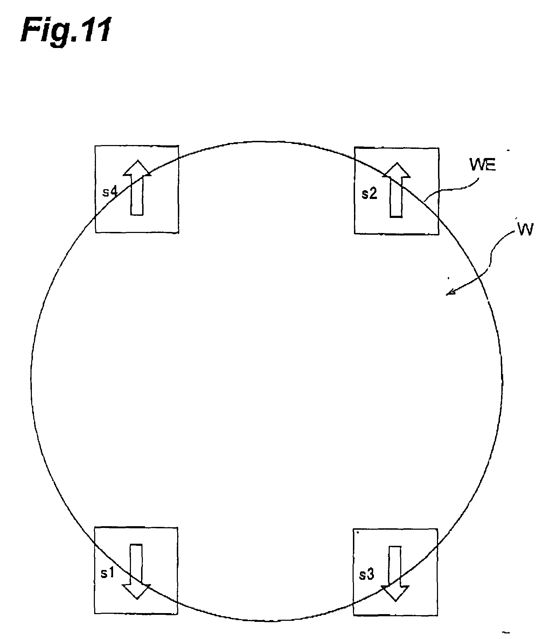

Also, as an application of the present invention, for example, as shown in Fig. 11, the order of exposure of the shot areas s2 and s3 in Fig. 9 may be reversed, so as to make it unnecessary to execute the operation for returning the reticle R.

Recently under study is a so-called complete alternate scanning system in which, when shot areas on a wafer are successively exposed by a scanning type exposure apparatus, scanning directions in the respective shot areas are alternately switched between the direction from the inside to outside of the wafer W and the direction from the outside to inside of the wafer W for not only the shot areas within the wafer but also edge shots, thus making it unnecessary to execute the returning operation of the reticle, thereby improving throughput.

In this complete alternate scanning system, upon exposure of an edge shot, when the scanning direction is directed from the inside to outside of the wafer W (the scanning locus of the center of the exposure area IA intersecting with the edge WE of the wafer W), no problem would occur, since focus can be detected at the position where scanning is started. By contrast, when the scanning direction is directed from the outside to inside of the wafer W, focus is hard to detect at the position where scanning is started, thereby requiring means for preventing the focus control from delaying. As such means, while performing the scanning exposure of an edge shot in which the scanning direction is directed from the inside to outside of the wafer W, at the same time when or immediately before the detection point of the focus detecting system reaches the wafer edge WE as the wafer W is moved, the focus control operation is stopped so that the optical axis direction position of the wafer W is held at this position. While the scanning exposure of the adjacent edge position, which is the next shot area, is executed along the scanning direction from the outside to inside of the wafer W, at the point of time when the detection point of the focus detecting system reaches the inside of the edge WE of the wafer W as the wafer W moves, focus control is started from the preset optical axis direction position, thereby preventing the focus control from delaying. Namely, this technique holding the optical axis direction position of the previous shot prevents the focus control from delaying, assuming that there is substantially no difference between the optical axis direction position of the wafer surface at the time when focus control is interrupted during the scanning exposure of the previous shot and the optical axis direction position of the wafer surface at the time when focus control is started during the scanning exposure of the next shot area (adjacent shot area).

The actual exposure sequence, however, is not always a sequence in which adjacent shots on the wafer W are successively exposed. For example, there is a case where a specific plurality of edge shots not adjacent to each other are made different from the other shot areas in terms of size, and the former shot areas are to be exposed after the exposure of the latter shot areas. In this case, when the exposure of the specific plurality of edge shots is executed by the complete alternate scanning using the above-mentioned technique holding the optical axis direction position of the previous shot, there is a possibility that, due to irregularities and inclination of the surface of the wafer W, the optical axis direction position of the surface of the wafer W at the point of time when the focus control of the previous shot is terminated may greatly differ from that at the point of time when the focus control of the next shot area is started. In this case, the amount of drawing the focus may increase so much that the focus control delays, thereby generating a defocus state. Similar results may also occur in the case where the scanning exposure of the adjacent shot area is executed by the above-mentioned complete alternate scanning when the number of shot areas on the wafer W is small while the size of each shot area is large.

By contrast, the present invention can provide an exposure apparatus and exposure method in which, even in the case where edge shots on the photosensitive substrate wafer necessitating at least a predetermined distance of stepping are successively exposed, throughput hardly decreases, and a defocus state (color irregularity) can be prevented from occurring due to delay in focus control.

### Second Embodiment

In the following, the second embodiment of the exposure apparatus and exposure method according to the present invention will be explained. Since the structure of the exposure apparatus and its basic scanning exposure operations according to the second embodiment are similar to those in the first embodiment, their overlapping explanations will not be repeated (see Figs. 2 and 3).

The difference of the second embodiment from the first embodiment lies in the control operations of the first control unit 20 during the scanning exposure process. Accordingly, in the following, the second embodiment will be explained mainly in terms of its difference from the first embodiment.

Here, each constituent of the multipoint focus detecting system (40, 42) will be explained together with its operation. From the illumination light source 80 (see Fig. 2), illumination light with a wavelength to which the photoresist on the wafer is insensitive, different from the exposure light, is guided to the condenser lens 82 by way of the optical fiber bundle 81. The illumination light emitted from the optical fiber bundle 81 illuminates the pattern forming plate 83 by way of the condenser lens 82.

Formed on the pattern forming plate 83 are 45 pieces of slit-like aperture patterns arranged in a matrix of 5 rows by 9 columns. The illumination light transmitted through each slit-like aperture pattern of the pattern forming plate 83 (image luminous flux of the aperture pattern) is projected onto the exposure surface of the wafer W by way of the lens 84, mirror 85, and irradiation objective lens 86, whereby images of 5 × 9 = 45 slit-like aperture patterns in total on the pattern forming plate 83 are projected and formed onto the exposure surface of the wafer W. In practice, from a direction inclined with respect to the optical axis AX by a predetermined angle α, the image luminous flux of aperture patterns from the irradiation optical system 40 irradiates the wafer W surface (or the surface of the reference mark plate FM) within a plane forming an angle of 45 degrees with respect to each of YZ and XZ planes.

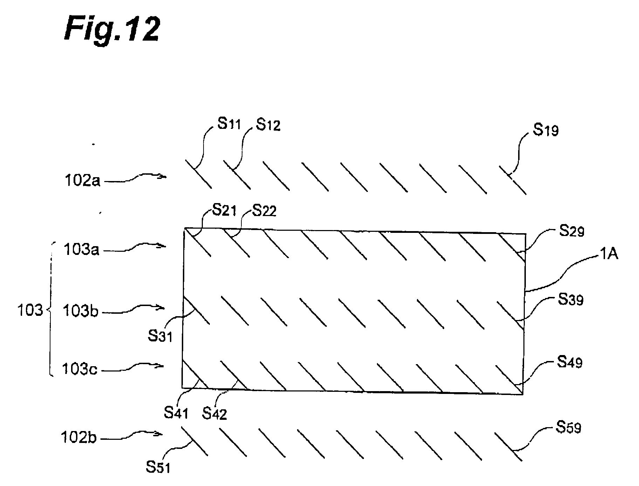

Consequently, as shown in Fig. 12, in the vicinity of the exposure area IA of the wafer W surface, 5 × 9, i.e., 45 images of slit-like aperture patterns (hereinafter referred to as slit images) S₁₁ to S₅₉, in total, arranged in a matrix of 5 rows by 9 columns are formed along X-axis direction and Y-axis direction with substantially the same intervals. A reflected luminous flux of the luminous flux of the slit images S₁₁ to S₅₉ from the wafer W surface advances in a direction inclined with respect to the optical axis AX by a predetermined angle a symmetrically with the image luminous flux from the irradiation optical system 40 and forms images again onto the light-receiving slit plate 98, which is disposed in front of the light-receiving device 90, by way of the condenser objective lens 87, rotational direction vibrating plate 88, and imaging lens 89.

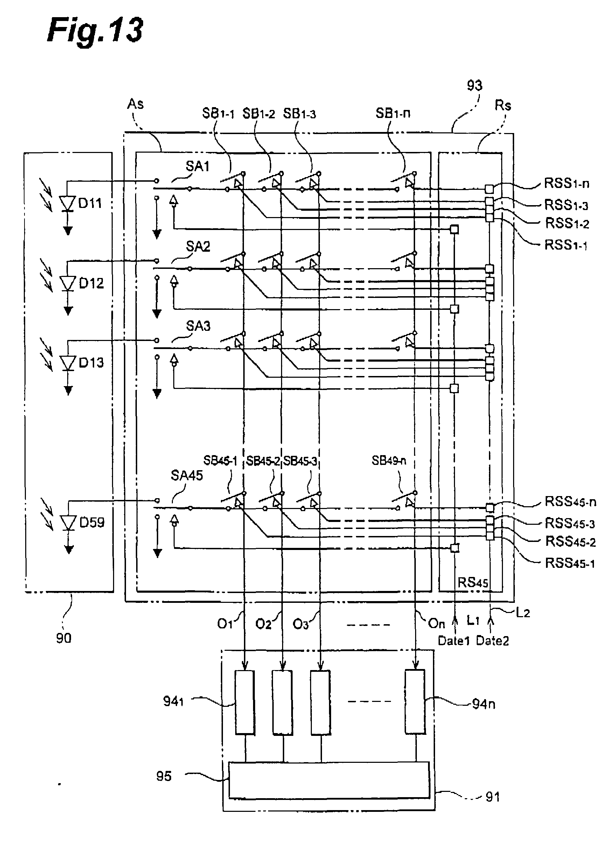

More specifically, on the light-receiving devise 90, 45 pieces of photosensors D₁₁ to D₅₉ (see Fig. 13) are arranged in a matrix of 9 rows by 5 columns so as to respectively correspond to the slit images S₁₁ to S₅₉. The light-receiving slit plate 98 disposed at the front surface (lower surface in Fig. 13) of the light-receiving device 90 is formed with slits respectively facing the individual photosensors D, and the slit images S₁₁ to S₅₉ shown in Fig. 12 respectively re-form images on these slits.

The main control unit 20 accommodates the oscillator (OSC) therein. When the vibrator 92, which is driven by a driving signal from the OSC according to an instruction from the main control unit, applies a predetermined vibration to the rotational direction vibrating plate 88, the position of each of the images re-formed on the light-receiving slit plate 98 vibrates in a predetermined direction (direction orthogonal to the longitudinal direction of each slit of the slit plate 98). Consequently, detection signals of the respective photosensors D₁₁ to D₅₉ are synchronously detected by a signal processing unit 91 according to signals of rotationally vibrating frequencies by way of the sensor selecting circuit 93. Then, a number of focus signals synchronously detected by the signal processing unit 91 are supplied to the main control unit 20. The sensor selecting circuit 93 and signal processing unit 91 will be explained later. Between the imaging lens 89 and the slit plate 98, a plane-parallel for shifting the relative relationship between the slit on the slit plate 98 and the center of vibration of the reflected slit image from the wafer W toward a direction orthogonal to the longitudinal direction of each slit of the slit plate 98 may be disposed.

As can be seen from the foregoing explanation, in the second embodiment, the individual slit images S₁₁ to S₅₉, which are detection points on the wafer W, and the individual photosensors D₁₁ to D₅₉ on the light-receiving device 90 correspond to each other one by one. Accordingly, the information of the position of each slit image on the wafer surface in the Z-axis direction (focus information) can be obtained according to the focus signal, which is an output from each photosensor. Therefore, in the explanation of the second embodiment, the slit images S₁₁ to S₅₉ will be referred to as focus sensors unless it is necessary for them to be specified otherwise in particular.

Of the focus sensors S₁₁ to S₅₉, outputs of the focus sensors S₂₁ to S₂₉ in the second row, focus sensors S₃₁ to S₃₉ in the third row, and focus sensors S₄₁ to S₄₉ in the fourth row positioned within the exposure area IA in Fig. 12 are used for follow-up control of the substrate table 18 for setting the surface position within the exposure area IA. Accordingly, these three rows of focus sensors are respectively referred to as follow-up sensors 103a, 103b, and 103c. Also, these three rows of focus sensors are collectively referred to as a follow-up sensor 103.

On the other hand, in the second embodiment, outputs of the first row of focus sensors S₁₁ to S₁₉ and fifth row of focus sensors S₅₁ to S₅₉ are used only for forecasting the next focus state, i.e., whether the wafer W surface changes in +Z or -Z direction. Consequently, these two rows of focus sensors are respectively referred to as pre-reading sensors 102a and 102b. Each of the pre-reading sensors 102a and 102b may be constituted by a plurality of rows of sensors as with the follow-up sensor 103. In this case, leveling control can also be forecasted.

In the following, configurations of the sensor selecting circuit 93 and signal processing unit 91 will be explained with reference to Fig. 13. This drawing schematically shows the sensor selecting circuit 93 and signal processing unit 91 together with the light-receiving device 90. Among them, the sensor selecting circuit 93 comprises a switch section Aₛ and a register section Rₛ. Disposed within the switch section Aₛ are changeover switches SA₁ to SA₄₅ in each of which one fixed contact is connected to the P side of its corresponding one of the photosensors (photodiodes herein) D₁₁, D₁₂, ..., and D₅₉ to which a reverse bias voltage is applied; and (45 × n) pieces of make-and-break switches SB₁₋₁, SB₁₋₂, SB₁₋₃,..., and SB₄₅₋ₙ respectively disposed between movable contacts (common contacts) of the changeover switches SA₁ to SA₄₅ and n output lines O₁ to Oₙ. The other fixed contact of each of the changeover switches SA₁ to SA₄₅ is grounded. On the other hand, the N side of each of the photosensors D₁₁ to D₅₉ is connected to a non-depicted power supply circuit. The n output lines O₁ to Oₙ for photoelectrically converted signals are respectively connected to signal processing circuits 94₁ to 94ₙ disposed so as to correspond to these output lines.

As a result of the foregoing configuration, for example, when the changeover switch SA₁ is switched toward the photosensor D₁₁, and the make-and-break switch SB₁₋₁ is turned on, a reverse current (photocurrent, i.e., photoelectrically converted signal) with a strength in proportion to the intensity of light received by the photosensor D₁₁ flows within a closed circuit from the photosensor D₁₁ to the switch SA₁ and the switch SB₁₋₁, successively. This current is detected by the signal processing circuit 94₁ and is converted thereby into a digital signal, which is sent to a signal output circuit 95. On the other hand, for example, when the changeover switch SA₄₅ is switched toward the photosensor D₅₉, and the make-and-break switch SB₄₅₋ₙ is turned on, a reverse current (photocurrent) with a strength in proportion to the intensity of light received by the photosensor D₅₉ flows within a closed circuit from the photosensor D₅₉ to the switch SA₄₅ and the switch SB₄₅₋ₙ, successively. This current is detected by the signal processing circuit 94ₙ and is converted thereby into a digital signal, which is sent to the signal output circuit 95. Thus, in the second embodiment, when a given combination of changeover switch SA and make-and-break switch SB is turned on, a photocurrent corresponding to the intensity of light received by any photosensor D can be taken out through a desired output line O.

Disposed within the register section Rₛ are 45 pieces of first registers RS₁ to RS₄₅ respectively disposed so as to correspond to the changeover switches SA₁ to SA₄₅; and 45 sets of second registers RSS₁₋₁ to RSS₄₉₋ₙ disposed n by n so as to correspond to the make-and-break switches SB₁₋₁ to SB₄₅₋ₙ. The first registers RS₁ to RS₄₅ are commonly connected to a single line L₁, whereas the second registers RSS₁₋₁ to RSS₄₅₋ₙ are commonly connected to a single line L₂. Accordingly, for example, in order for the output of the photosensor D₁₁ to be fed to the output line O₁, Data 1 ("1, 0, 0, ..., 0") and Data 2 ("1, 0, 0, 0, 0, 0, 0, 0, 0, 0, 0, 0, 0, 0, ..., 0, 0, 0, 0, 0, 0, 0") are respectively fed into the lines L₁ and L₂. As a result, while the first register RS₁ and the second register RSS₁₋₁ are set to "1" the other registers become zero. Further, the changeover switch SA₁ is switched toward the photosensor D₁₁, and the make-and-break switch SB₁₋₁ is turned on, whereby the output of the photosensor D₁₁ is fed to the output line O₁. Thus, in the second embodiment, depending on the contents of Data 1 and Data 2 fed into the register RS from the main control unit 20 respectively by bay of the lines L₁ and L₂, the output of a desired photosensor D can he fed to a desired output line O, i.e., to the signal processing circuit 94 corresponding thereto. Accordingly, in the case where n = 45, for example, when the individual photosensors D are respectively connected to the signal processing circuits 94₁ to 94ₙ independently of each other, the main control unit 20 can compute the positions of focus sensors, which are individual detection points of the exposure area IA and within detection areas in front thereof and therebehind, in the optical axis direction.

The signal processing unit 91 comprises n pieces of signal processing circuits 94₁ to 94ₙ respectively connected to the output lines O₁ to Oₙ. Each signal processing circuit 94 accommodates therein a synchronous detection circuit (PSD), into which an AC signal having a phase identical to that of the driving signal from the OSC is fed. By using the phase of the AC signal as a reference, each signal processing circuit 94 performs synchronous rectification (synchronous detection) of the signal from its corresponding output line, thereby generating a focus position detection signal (focus signal) FS corresponding to the Z-axis direction position (focus position) of the site of each of the slit images S₁₁ to S₅₉ on the wafer W. Then, the focus signals FS from the signal processing circuits 94₁ to 94ₙ are digitally converted by the signal output circuit 95, so as to be fed to the main control unit 20 as serial data.

Meanwhile, each focus signal FS is a so-called S-curve signal which becomes zero level in the state where the slit center of the light-receiving slit plate 98 coincides with the vibration center of the reflected slit image from the wafer W, a positive level when the wafer W is displaced upward from this state, and a negative level when the wafer W is displaced downward from this state. Accordingly, when no offset is added to each focus signal FS, the height position (optical axis direction position) of the wafer W where each focus signal FS becomes zero level is detected by the main control unit 20 as an in-focus point.

As mentioned above, in the second embodiment, the output of a desired photosensor D can be fed to a desired output line O, i.e., to a signal processing circuit 94 corresponding thereto. For example, in the case where a plurality of photosensors D are set to the same output destination, the signal processing circuit 94 designated (selected) as the output destination synchronously detects the combined signal of photosensor outputs according to the signal of rotational vibration frequency, whereby the digitally converted data of the focus signal corresponding to the combined signal of outputs of the plurality of photosensors are fed to the main control unit 20.

As mentioned previously, since the pre-reading sensors 102a and 102b are used only for forecasting the next focus state, it is assumed that the photosensors D₁₁ to D₁₉ corresponding to the respective focus sensors of the pre-reading sensor 102a and the photosensors D₅₁ to D₅₉ corresponding to the respective focus sensors of the pre-reading sensor 102b are respectively connected to the output lines O₁ and Oₙ , each of which is a single output destination. Also, in order for the photosensors D₂₁ to D₂₉, D₃₁ to D₃₉, and D₄₁ to D₄₉ corresponding to the respective focus sensors constituting the follow-up sensor 103 to be connectable to output lines O₂ to Oₙ₋₁,it is assumed that n > 29, for example.

Further, in the scanning type exposure apparatus according to the second embodiment (see Fig. 9), as methods of focus control and leveling control when the pattern of the reticle R is projected and exposed onto each shot area on the wafer W, the following three control methods different from each other are performed.

Namely, the first control method is usual autofocus control and auto-leveling control which, according to a focus signal corresponding to each focus sensor constituting the follow-up sensor 103, drive the substrate table 18 in Z direction and incline it in X and Y directions.

The second control method is irregular autofocus control and leveling control which, according to focus signals corresponding to a plurality of focus sensors constituting the follow-up sensor 103, drive the substrate table 18 in Z direction and incline it in X direction.

The third control method is autofocus control which, according to a focus signal corresponding to one or more sensors constituting the follow-up sensor 103, only drives the substrate table 18 in Z direction.

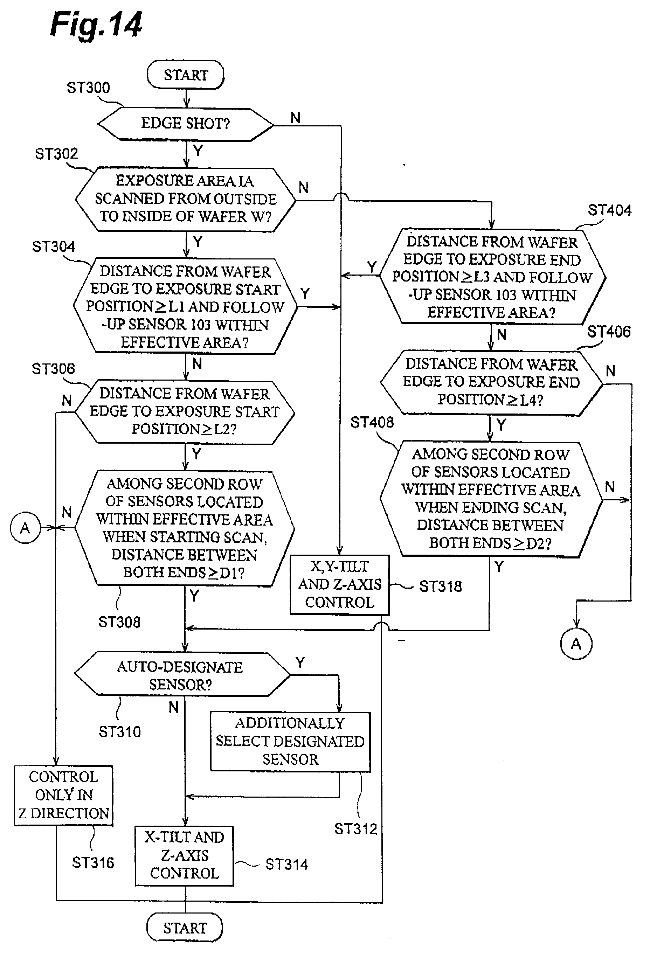

Here, the focus control and leveling control of the main control unit 20 including the judgment of the first to third control methods upon scanning exposure will be explained with reference to the flowchart of Fig. 14. This flowchart is actually a part of an exposure processing program and, for example, is repeatedly performed before starting the scanning of each shot area for each scanning exposure operation of the shot area.

First, whether the shot area to be exposed is a shot area in the peripheral portion of the wafer W or not is judged (step ST300). The judgment at this step ST300 is executed according to predefined shot map data (stored in the memory 200) including data concerning positions of shot areas, exposure order, and the like. If this judgment is negative, then the stage control system 19 controls the wafer driving unit 21 according to each focus signal from the follow-up sensor 103 of the multipoint focus position detecting system (40, 42) during the scanning exposure of this shot area, whereby the usual autofocus control and auto-leveling control for X-tilting, Y-tilting, and Z-driving of the substrate table 18 are executed (step ST318).

If the judgment at the step ST300 is positive, by contrast, then whether or not the exposure area IA is scanned from the outer peripheral portion of the wafer W to the inside thereof during the scanning exposure of the shot area is judged (step ST302). If this judgment is positive, then it is judged whether or not the distance from the outer edge (hereinafter referred to as wafer edge WE) of the effective area of the wafer W to the exposure start position of the shot area is at least a first predetermined distance L1 and the follow-up sensor 103 is within the effective area of the wafer W at the point of time when starting the scanning (step ST304). Since how much the scanning start position is distanced from the wafer edge WE has been known from the coordinates of the wafer edge WE, shot map data, and the like, and the relative positional relationship between the scanning start position and the focus sensor has been known, the above-mentioned judgment is executed based thereon. Here, the effective area of the wafer W basically refers to the main surface of the wafer W. In the case where the peripheral portion of the wafer W is provided with a pattern inhibition zone, it refers to the inside of the pattern inhibition zone. Accordingly, in this specification, the edge WE of the wafer W (photosensitive substrate) is a concept encompassing both the edge of the wafer W itself and the inner edge of the pattern inhibition zone (outer edge of the effective area). The first predetermined distance L1 refers to, of an approach distance from the scanning start position to the exposure start position, a distance necessary for the driving system to follow up in order to tilt the substrate table 18 in X and Y directions (i.e., stroke necessary for drawing X-tilt and Y-tilt).

If the judgment at the step ST304 is positive, the usual focus control and leveling control for X-tilt, Y-tilt, and Z-axis control of the substrate table 18 are executed (step ST318). If the judgment at the step ST304 is negative, by contrast, then it is judged whether or not the distance from the wafer edge WE to the exposure start position in the shot area is at least a predetermined distance L2 (step ST306). This judgment is executed similarly to that at the above-mentioned step ST304. Here, the second predetermined distance L2 refers to, of an approach distance from the scanning start position to the exposure start position, a distance necessary for the driving system to follow up in order to tilt the substrate table 18 in a non-scanning direction (which is X direction different from Y direction herein). If the judgment at the step ST306 is negative, then the stage control system 19 controls the wafer driving unit 21 according a focus signal corresponding to one or more sensors constituting the follow-up sensor 103 during the scanning exposure of the shot area, whereby focus control for controlling the substrate table 18 only in Z direction is executed (step ST316).

If the judgment at the step ST306 is positive, then it is judged, of the second row of the focus sensors located within the effective area at the point of time when the scanning is started, whether or not the distance between both end sensors is at least a predetermined distance D1 (step ST308). This judgment is executed according to the designed value of distance between sensors which are selected as focus sensors used for surface position adjustment of the wafer W at this point of time, and the positional relationship between the sensors and an edge shot. Here, the predetermined distance D1 is a value determined according to the resolution of the photosensor D and the performance of hardware constituting the driving system for the substrate table 18. If the judgment at the step ST308 is negative, then the Z-direction control is also executed (step ST316). If the judgment at the step ST308 is positive, then it is judged whether or not there is automatic designation of sensors (step ST310). In the case where the operator has instructed automatic designation of a sensor (including which sensor to be additionally designated) through an input device such as the console 201, this command exists, for example, in a temporary storage area within the memory 200. Accordingly, this judgement is executed by reading this area. Of course, when only sensors are additionally designated (additionally selected) as much as possible, it is sufficient for the operator to instruct only the automatic designation of the sensors. In this case, whether automatic designation of sensors is executed or not can be judged by simply seeing if a flag corresponding thereto is on or off.

If the judgment at the step ST310 is negative, then the stage control system 19 controls the wafer driving unit 21 according to focus signals corresponding a plurality of sensors constituting the follow-up sensor 103 during the scanning exposure of the shot area, thereby executing the irregular autofocus control and levelinq control for X-tilting and Z-axis control of the substrate table 18 (step ST314). If the judgment at the step ST310 is positive, the designated focus sensor is additionally selected according to the command existing within the temporal storage area (step ST312), and then the focus control and leveling control for X-tilting and Z-axis control of the substrate 18 are executed (step ST314). Here, the additional selection of sensor at the step ST312 in practice is executed when the photosensor designated by way of the sensor selecting circuit 93 located within the effective area at the point of time when starting the scanning (or at the point of time when terminating the scanning in the case by way of step ST408 explained later), corresponding to the one between both end sensors, is connected to any of unused signal processing circuits. In the case where focus information data at all the detection points (slit image positions) are not used for surface position adjustment, apart of detection points may be located outside the effective area on the wafer W upon scanning exposure of a so-called chipped shot. In such a case, according to the automatic sensor designation, detection points which have not been used for surface position adjustment are additionally selected within the effective area on the wafer W, and focus information data from these detection points are also used so as to more accurately execute tilt control in the non-scanning direction (X direction herein).

If the judgment at the step ST302 is negative, i.e., in the case where the exposure area IA is scanned from the inside to outside of the wafer W during the scanning exposure of the shot area, it is judged whether or not the distance from the outer edge (wafer edge WE) of the effective area of the wafer W to the exposure end position of the shot area is at least a third predetermined distance L3 and the follow-up sensor 103 is within the effective area of the wafer W at the point of time when terminating the exposure (step ST404). As with the above-mentioned step ST304 , since how much the scanning start position is distanced from the wafer edge WE has been known from the coordinates of the wafer edge WE and the like included in the shot map data, and the relative positional relationship between the exposure end position and the focus sensor has been known, the above-mentioned judgment is executed based thereon. Here, the third predetermined distance L3 refers to, of the shortest distance from the exposure end position to the wafer edge WE, a distance necessary for the driving system to follow up in order to tilt the substrate table 18 in X and Y directions ( i.e., stroke necessary for drawing X-tilt and Y-tilt).

If the judgment at the step ST404 is positive, then the above-mentioned focus control and leveling control at step ST318 are executed. If the judgment at the step ST404 is negative, by contrast, then it is judged whether or not the distance from the wafer edge WE to the exposure end position in the shot area is at least a predetermined distance L4 (step ST406). This judgment is executed similarly to that at the step ST304. Here, the fourth predetermined distance L4 refers to, of the distance from the exposure end position to the wafer edge WE, a distance necessary for the driving system to follow up in order to tilt the substrate table 18 in the non-scanning direction (X direction herein) (i.e., stroke necessary for drawing X-tilt). If the judgment at the step ST406 is negative, then the stage control system 16 controls the wafer driving unit 21 according to a focus signal corresponding to one or more sensors constituting the follow-up sensor 103 during the scanning exposure of the shot area, thereby executing the focus control for controlling the substrate table 18 only in Z direction (step ST316).

If the step ST406 is positive, then it is judged, of the second row of the focus sensors located within the effective area at the point of time when the scanning is terminated, whether or not the distance between both end sensors is at least a predetermined distance D2 (step ST408). This judgment is executed similarly to that at the above-mentioned step ST308. Here, the predetermined distance D2 is a value determined according to the resolution of the photosensor D and the performance of hardware constituting the driving system for the substrate table 18. If the judgment at the step ST408 is negative, only the focus control at the step ST316 is executed. If the judgment at the step ST408 is positive, then it is judged whether or not there is automatic designation of sensors and the like as mentioned above (step ST310) and, according to the result of judgment, one of the processing operations of steps ST312 and ST314 is executed. In this case, at the step ST312, as mentioned above, the additional selection of sensor is executed when the photosensor designated by way of the sensor selecting circuit 93 located within the effective area at the point of time when terminating the scanning, corresponding to the one between both end sensors, is connected to any of unused signal processing circuits.

After the focus control and leveling control of the foregoing routine are completed, the reticle pattern is transferred to the shot area (by scanning the exposure area IA in the designated scanning direction). The wafer in which the scanning exposure has been completed in all the shot areas is subjected to processes such as development, etching, and doping, and then, with a resist coated thereon, is exposed to light under the above-mentioned focus control and leveling control. As the foregoing operation is repeated, IC circuit patterns are formed on the wafer (by the circuit making method according to the present invention).

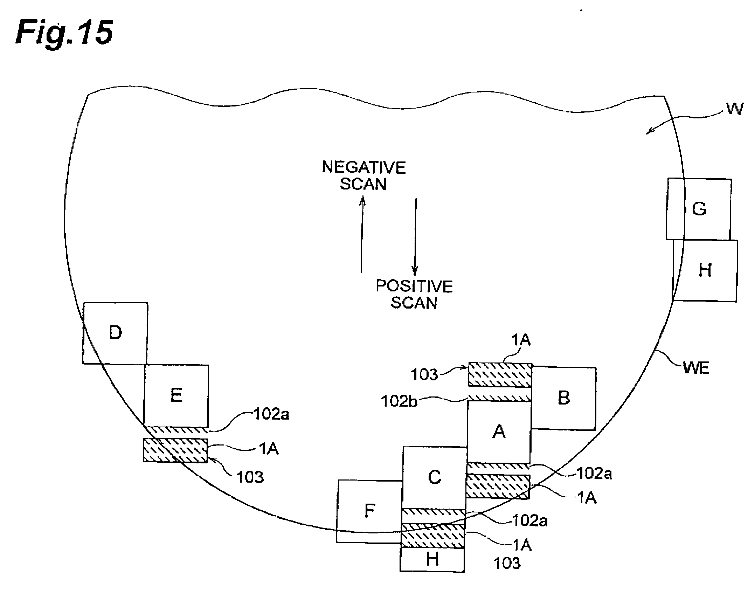

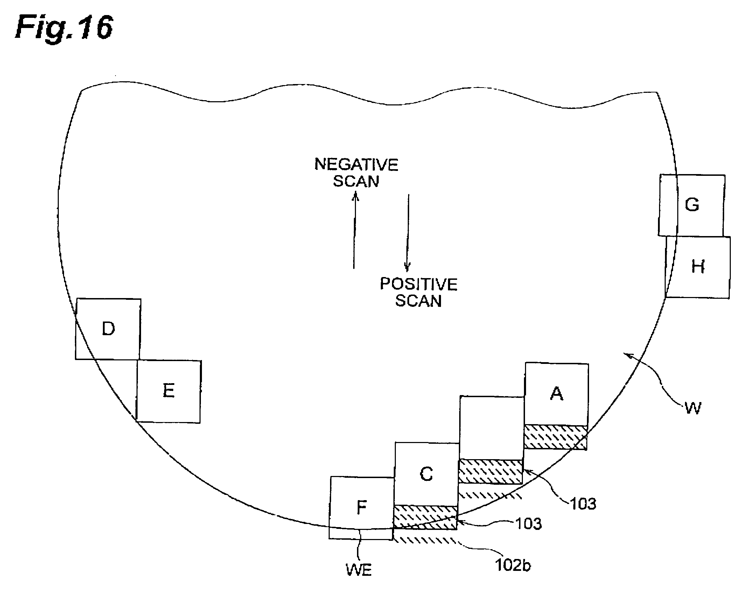

In the following,specific examples of the focus control and leveling control in conformity to the flowchart of Fig. 14 described above will be explained with reference to Figs. 15 and 16 in the following.

For example, in Fig 15, in an exposure sequence employing, upon scanning exposure of a shot area A, which is one of peripheral shot areas, the negative scanning direction in which the exposure area IA is scanned from the inside to outside of the wafer W (in practice, the wafer W is scanned in the positive scanning direction while the exposure area IA is stationary) as the moving direction of the substrate table 18, the steps ST300, ST302, ST404, and ST318 are performed in this order. Consequently, as with the inner shots other than the peripheral shot areas, the focus control and leveling control using the pre-reading sensor 102b and follow-up sensor 103 are executed. Namely, in the main control unit 20, the fluctuation of the wafer W surface in Z direction is forecasted by the pre-reading sensor 102b, and the substrate 18 is driven in Z direction and tilted in X and Y directions according to the focus signal corresponding to each focus sensor of the follow-up sensor 103, thereby executing the surface position adjustment.

In an exposure sequence in which, when scanning exposure of the shot area A is executed, without automatic sensor designation, the positive scanning direction opposite to the negative scanning direction explained above is selected as the scanning direction of the substrate table 18, the steps ST300, ST302, ST304, ST306, ST308, ST310, and ST314 are performed in this order. Consequently, the focus control using the pre-reading sensor 102b and follow-up sensor 103 is executed. In this case, since the distance from the wafer edge WE to the exposure start position is smaller than the first predetermined distance L1, the judgment at the step ST304 is made negative, thus making it difficult to draw tilting in the scanning direction (Y direction herein). Accordingly, by using the follow-up sensor 103a or 103b or follow-up sensors 103a and 103b, the focus control enabling the leveling control only in the non-scanning direction (X direction) is executed. Namely, while forecasting the fluctuation of the wafer W surface in Z direction by the pre-reading sensor 102a, the main control unit 20 drives the substrate table 18 in Z direction and tilts it in X and Y directions according to the focus signal corresponding to the follow-up sensor 103a or 103b or follow-up sensors 103a and 103b, thereby executing the surface position adjustment. This procedure is employed since, as can be seen from Fig. 15, a part of the sensor 103c is located outside the wafer W and thereby the leveling control of the portion corresponding to the exposure area IA may not be executed correctly.

On the other hand, for example, when scanning exposure of a shot area C in Fig. 15 is executed along the positive scanning direction, the steps ST300, ST302, ST304, ST306, and ST316 are performed in this order. Consequently, only the focus control is executed. In this case, by the time when a part of the follow-up sensor 103 enters onto the wafer W, the pre-reading sensor 102a has already reached the exposure start position. Accordingly, by the time when the sensor 103 reaches a position enabling the leveling control, scanning exposure has already begun. Therefore, the main control unit 20 performs the focus control by using only the focus sensor located within the effective area of the wafer W, e.g., focus sensor S₂₁, at the time when scanning is started. In this case, since the leveling control (tilting control of the substrate table 18) is not executed, it is preferred that the substrate table 18 be set in parallel to the image surface of the projection optical system PL beforehand.

In the following, the case with automatic sensor designation will be explained as exemplified by the case in which scanning exposure of a shot area E in Fig. 15 is executed along the positive scanning direction. As a prerequisite, it is assumed that all the selectable sensors are objects of additional selection, and that the focus sensors S₂₁, S₂₃, S₂₅, S₂₇, S₂₉, S₃₁, S₃₃, S₃₅, S₃₇, S₃₉, S₄₁, S₄₃, S₄₅, S₄₇, and S₄₉ are selected in the initial setting.

In this case, the steps ST300, ST302, ST304, ST306, ST308, ST310, ST312, and ST314 are performed in this order. Consequently, the focus control is executed by using the pre-reading sensor 102a and the follow-up sensor 103. As with the above-mentioned case of the scanning exposure of the shot area A along the positive scanning direction, since it is difficult to draw tilting in the scanning direction (Y direction herein), the focus control enabling the leveling control only in the non-scanning direction (X direction) is executed by using the follow-up sensor 103a or 103b or follow-up sensors 103a and 103b. Here, however, since the number of focus sensors that can be used for the leveling control in X direction is small, the focus sensors S₂₈, S₃₈, and S₄₈ are additionally selected at the step S312.

Also, for example, in Fig. 16, in an exposure sequence employing, upon the scanning exposure of the shot area A, which is one of peripheral shot areas, the negative scanning direction in which the exposure area IA is scanned from the inside to outside of the wafer W (in practice, the wafer W is scanned in the positive scanning direction while the exposure area IA is stationary) as the moving direction of the substrate table 18, when there is no automatic sensor designation, the steps ST300, ST302, ST404, and ST318 are performed in this order. Consequently, X- and Y-tilting (leveling) and the focus control and leveling control using the pre-reading sensor 102a and follow-up sensor 103 are executed.

On the other hand, for example, when scanning exposure of a shot area C in Fig. 16 is executed along the negative scanning direction, the steps ST300, ST302, ST404, ST406, and ST316 are performed in this order. Consequently, only the focus control is executed. In this case, when a part of the follow-up sensor 103 reaches the exposure end position, a part of the follow-up sensor 103 is located outside the wafer edge WE, whereby a part of the follow-up sensor 103 becomes incapable of measurement during the scanning exposure of the shot area C. Therefore, the main control unit 20 performs the focus control by using only the focus sensor located within the effective area of the wafer W, e.g., focus sensor S₄₁, at the time when scanning is started. In this case, since the leveling control (tilting control of the substrate table 18) is not executed, it is preferred that the substrate table 18 be set in parallel to the image surface of the projection optical system PL beforehand.

When, as in the above-mentioned case of the positive scanning in the shot area A or the positive scanning in the shot area C in Fig. 15 or the negative scanning in the shot area C in Fig. 16, at least one of the X-direction leveling and Y-direction leveling of the substrate table 18 cannot be executed, the main control unit 20 may store information about inclination of the wafer W upon exposure of the shot (usually an adjacent shot) immediately prior to the shot area A or C to be exposed into a memory beforehand and use this information so as to execute the leveling control in the direction incapable of the leveling control (Y direction, which is the scanning direction, in the case of the shot area A in Fig. 15; both X and Y directions in the shot area C in Figs. 15 and 16). Of course, even in this case, as mentioned above, the focus control and the other of the X-direction leveling and Y-direction leveling controls (the focus control and the leveling control in X direction, which is the non-scanning direction, in the shot area A in Fig. 15; the focus control in the shot area C in Figs. 15 and 16) are executed according to the result of detection of the multipoint focus position detecting system. As a consequence, finally, the focus control and leveling control can be executed according to the leveling information upon exposure of the adjacent shot and the result of focus detection upon exposure of the shot area. Also, when a sensor is additionally selected as in the case of exposure of the above-mentioned shot area E in Fig. 15, the main control unit 20 may store information about inclination of the wafer W upon exposure of the adjacent shot into a memory beforehand and use this information so as to execute the leveling control in the scanning direction. In such a case, the main control unit 20 realizes the above-mentioned fifth exposure control.

While specific examples of the focus control and leveling control are explained in the foregoing with reference to Figs. 15 and 16, optimal focus control is possible when scanning exposure of a shot area is executed at any place according to the flowchart of Fig. 14. Namely, focus control from the vicinity of the wafer edge is also possible in so-called chipped shots such as shot areas D, F, G, and H in Fig. 15.

As explained in the foregoing, in the second embodiment, in any peripheral shot area, in either positive scanning or negative scanning, optimal focus control can be executed upon scanning exposure. Consequently, an impermissible defocus state can be prevented from occurring, whereby color irregularity can be kept from occurring due to the defocus state. Further, unconditionally possible is the most efficient alternate scanning in which scanning exposure is executed such that the reticle stage and substrate table are moved so as to alternately reverse the scanning directions. Consequently, both prevention of color irregularity and improvement in throughput can be attained at the same time. Also, as the color irregularity is prevented from occurring, the resolution of the circuit pattern can be kept from deteriorating. Accordingly, the yield of the product (semiconductor device) manufactured thereby can be improved or prevented from deteriorating.

Explained in the second embodiment is the case where operations for (a) focus control and X-tilt control, (b) focus control and X- and Y-tilt control, and (c) focus control alone are selectively executed according to the flowchart of Fig. 14. Without being restricted thereto, however, for example, the positional relationship between each shot area and the wafer edge can be determined at the point of time when preparing an exposure map concerning which shot arrangement is employed on the wafer W and in which order the exposure is executed. Accordingly, by which control operations of (a) to (c) the surface position adjustment is to be executed for each shot area may be specified as table data and stored in a memory, and the surface position adjustment may be performed according to this table data when the scanning exposure is executed. Also employable is a system in which the above-mentioned control operations of (a) to (c) are combined together.

The above-mentioned judging function addition of automatic sensor designation function, and the like in the second embodiment can be executed by simple alternation of software.

As explained in the foregoing, the second embodiment according to the present invention is unconventionally effective in concurrently achieving the prevention of the color irregularity caused by the occurrence of a defocus state during exposure processing and the improvement in throughput.

Also, the yield of products (semiconductor devices such as circuit) and the like can be prevented from deteriorating due to the occurrence of color irregularity caused by the defocus state during the exposure processing.

From the invention thus described, it will be obvious that the invention may be varied in many ways. Such variations are not to be regarded as a departure from the spirit and scope of the invention, and all such modifications as would be obvious to one skilled in the art are intended for inclusion within the scope of the following claims.

## Claims

1. An exposure apparatus transferring a pattern onto a substrate while relatively moving a predetermined energy beam and said substrate, said exposure apparatus comprising:
a focus detecting system for detecting a focus position of said substrate; and
a control system for controlling scanning exposure on the basis of a positional relationship between a first shot area and a second shot area onto which said pattern should be transferred next said first shot area.

2. An exposure apparatus according to claim 1, wherein said control system controls the scanning exposure on the basis of information regarding whether a distance between said first and said second shot areas is not less than a predetermined distance.

3. An exposure apparatus according to claim 2, wherein, prior to executing the scanning exposure for said second shot area; said control system evaluates both conditions in which a detection point of said focus detecting system intersects with an edge of said substrate and in which said distance between said first and second shot areas is said predetermined distance or more.

4. An exposure apparatus according to claim 3, wherein said control system controls the scanning exposure for said second shot area so that said detection point of said focus detecting system does not intersect with said edge of said substrate.

5. An exposure apparatus according to claim 4, wherein said focus detecting system is disposed at a predetermined position with respect to said energy beam, and
when said control system controls relative positions of said energy beam and said focus detecting system with respect to said substrate.

6. An exposure apparatus according to claim 1, wherein said control system controls the scanning exposure on the basis of an arrangement information of said first and second shot areas on said substrate.

7. An exposure apparatus according to claim 1, wherein at least a part of a detection area of said focus detecting system overlaps an exposure area of said energy beam.

8. An exposure apparatus according to claim 2, wherein, when said distance between said first and second shot areas is said predetermined distance or more, said control system controls to stop a relative movement of said energy beam and said substrate in order to a focus detection of said focus detecting system, and thereafter controls to relatively move said energy beam and said substrate.

9. An exposure apparatus according to claim 8, wherein, prior to executing the scanning exposure for said second shot area, said control system evaluates both conditions in which a detection point of said focus detecting system intersects with an edge of said substrate and in which said distance between said first and second shot areas is said predetermined distance or more.

10. An exposure apparatus according to claim 9, wherein said control system controls relative positions of said energy beam and said substrate so that said energy beam moves from outside to inside of said substrate.

11. An exposure apparatus according to claim 2, wherein said control system selects one of a first mode for controlling relative positions of said energy beam and said substrate so that said energy beam moves from inside to outside of said substrate, and a second mode for relatively moving said energy beam and said substrate after said focus detecting system performs a focus detection while stopping a relative movement of said energy beam and said substrate,

12. An exposure apparatus according to claim 1, wherein said pattern is transferred onto said substrate through a projection optical system, and a focus position is on an optical axis direction of said projection optical system.

13. An exposure method of transferring a pattern onto a substrate while relatively moving a predetermined energy beam and said substrate, said exposure method comprising the steps of:
detecting a focus position of said substrate; and
controlling scanning exposure on the basis of a positional relationship between a first shot area and a second shot area onto which said pattern is transferred next said first shot area.

14. An exposure method of transferring a pattern onto a substrate while relatively moving a predetermined energy beam and said substrate, said exposure method comprising the steps of:
detecting a focus position of said substrate; and
selecting one of a first mode for controlling relative positions of said energy beam and said substrate so that said energy beam moves from inside to outside of said substrate, and a second mode for relatively moving said energy beam and said substrate after said focus detecting system performs a focus detection while stopping a relative movement of said energy beam and said substrate on the basis of a positional relationship between a first shot area and a second shot area onto which said pattern is transferred next said first shot area.

15. An exposure apparatus transferring a pattern onto a substrate while relatively moving an predetermined energy beam and said substrate, said exposure apparatus comprising:
a focus detecting system for detecting a focus position of said substrate; and
a control system for controlling at least one of said focus position and an inclination of said substrate on basis of a positional relationship between said substrate and a shot area on said substrate.

16. An exposure apparatus according to claim 15, wherein said control system controls at least one of said focus position and inclination of said substrate on the basis of a positional relationship between said focus detecting system, said substrate and said shot area on said substrate.

17. An exposure apparatus according to claim 15, wherein said control system controls at least one of said focus position and inclination of said substrate on the basis of a positional relationship between an edge of said substrate and said shot area on said substrate.

18. An exposure apparatus according to claim 17, wherein said edge of said substrate includes an outer edge of an effective area of said substrate.

19. An exposure apparatus according to claim 17, wherein said control system controls at least one of said focus position and inclination of said substrate on the basis of a distance between said edge of said substrate and an exposure start position in said shot area.

20. An exposure apparatus according to claim 19, wherein said control system controls at least one of said focus position of said substrate and said inclination of said substrate on the basis of a length of a shortest distance between said edge of said substrate and said exposure start position in said shot area.

21. An exposure apparatus according to claim 20, wherein said control system executes at least one of a control for said focus position of said substrate only and a control for both said focus position and inclination of said substrate on the basis of the length of the shortest distance between said edge of said substrate and said exposure start position in said shot area.

22. An exposure apparatus according to claim 21, wherein, when satisfied is a first condition in which the distance from said exposure start position to said edge of said substrate along a scanning direction is at least a first value and, of detection points of said focus detecting system, at least three points capable of defining said substrate exist on said substrate at the point of time when scanning is started, said control system executes a first adjustment operation for controlling said focus position of said substrate and a second adjustment operation for controlling said inclination of said substrate:
wherein, when satisfied is a second condition in which the distance from said exposure start position in said shot area to said edge of said substrate along said scanning direction is less than said first value but at least a second value smaller than said first value, and both end detection points in a detection point group arranged in a row orthogonal to the scanning direction and positioned on said substrate are separated from each other by a predetermined distance or more, said control system executes said first and second adjustment operations; and
wherein, when neither said first condition nor second condition is satisfied said control system executes only said first adjustment operation.

23. An exposure apparatus according to claim 17, further comprising:
a plurality of sensors prepared so as to respectively correspond to said plurality of detection points of said focus detecting system; and
a sensor selecting mechanism for selecting, of said plurality of sensors, a sensor utilized for positional adjustment of said substrate executed by said control system;
wherein said control system selects, of said plurality of detection points, a sensor positioned on said substrate at the point of time when scanning is started, by way of said sensor selecting mechanism.

24. An exposure apparatus according to claim 17, wherein said control system controls at least one of said focus position of said substrate and said inclination of said substrate on the basis of a distance between said edge of said substrate and an exposure end position in said shot area.

25. An exposure apparatus according to claim 21, wherein said control system controls at least one of said focus position of said substrate and said inclination of said substrate on the basis of a length of a shortest distance between said edge of said substrate and an exposure end position in said shot area.

26. An exposure apparatus according to claim 24, wherein, when satisfied is a third condition in which the distance from said exposure end position in said shot area to said edge of said substrate along the scanning direction is at least a third value and, of said plurality of detection points of said focus detecting system, at least three points capable of defining said substrate exist on said substrate at the point of time when scanning is completed, said control system executes a first adjustment operation for controlling said focus position of said substrate and second adjustment operation for controlling said inclination of said substrate;
wherein, when satisfied is a fourth condition in which the distance from said exposure end position in said shot area to said edge of said substrate along the scanning direction is less than said third value but at least a fourth value smaller than said third value, and both end detection points in a detection point group arranged in a row orthogonal to said scanning section and positioned on said substrate are separated from each other by at least a predetermined distance, said control system executes a first adjustment operation and a second adjustment operation different from said first adjustment operations; and
wherein, when neither said third condition nor fourth condition is satisfied, said control system executes only said first adjustment operation.

27. An exposure apparatus according to claim 17, further comprising:
a plurality of sensors prepared so as to respectively correspond to said plurality of detection points of said focus detecting system; and
a sensor selecting mechanism for selecting, of said plurality of sensors, a sensor utilized for positional adjustment of said substrate executed by said control system;
wherein said control system selects, of said plurality of detection points, a sensor positioned on said substrate at the point of time when scanning is terminated, by way of said sensor selecting mechanism.

28. An exposure method of transferring a pattern onto a substrate while relatively a predetermined energy beam and said substrate, said method comprising the steps of:
controlling at least one of a focus position of said substrate and an inclination of said substrate on the basis of a positional relationship between said substrate and a shot area on said substrate.
